# EUROPEAN PATENT APPLICATION

(11) **EP 4 750 288 A1**
(43) Date of publication of application: **27.05.2026**
(21) Application number: 25215440.6
(22) Date of filing: 13.11.2025
(51) Int. Cl.: H10K 59/121, H10K 59/35, H10K 59/38

(54) **DISPLAY PANEL AND ELECTRONIC DEVICE**

(30) Priority: 22.11.2024 KR 20240168984; 06.12.2024 KR 20240180730
(71) Applicant: Samsung Display Co., Ltd., Yongin-si, Gyeonggi-do 17113 (KR)
(72) Inventor: Lee, Sangshin, 17113 Giheung-gu, Yongin-si, Gyeonggi-do (KR); Kang, Yeonju, 17113 Giheung-gu, Yongin-si, Gyeonggi-do (KR); Lee, Yuri, 17113 Giheung-gu, Yongin-si, Gyeonggi-do (KR)
(74) Representative: Dr. Weitzel & Partner

(57) **Abstract**

A display panel and an electronic device are provided. The display panel includes a substrate including a display area, and a plurality of unit areas arranged on the substrate, the plurality of unit areas being adjacent to each other in the display area, wherein each of the plurality of unit areas includes a first display element, a second display element, and a third display element to emit different colors, the first display element, the second display element, and the third display element are arranged in each of the plurality of unit areas, the first display element includes a first distinguished display element in which a plan shape of an emission area is a polygon having a long side and a short side, and a second distinguished display element that is spaced from the first distinguished display element and in which a plan shape of an emission area is a polygon.

## Description

The present invention relates to a display panel and an electronic device including the same.

Mobility-based electronic devices are widely used. Recently, tablet personal computers (PCs), in addition to small electronic devices such as mobile phones, are widely used as the mobile electronic device.

In order to support various functions, the mobile electronic device includes a display panel for providing a user with visual information such as an image or a video. Recently, as other components for driving a display panel are miniaturized, the proportion of the display panel in an electronic device is gradually increased, and a structure that is bendable from a flat state to have a preset angle is developed.

In general, in a display panel, brightness, a lifetime and/or color coordinates of the display panel may vary according to an aperture ratio of each sub-pixel. The display panel may have various structures of a sub-pixel so as to obtain higher brightness in the same area. In this regard, there is a need for a sub-pixel structure by which an area of a light-emission area of a sub-pixel arranged in the same area is increased and brightness and/or a lifetime is increased or maximized. To do so, an aperture ratio of each sub-pixel may be adjusted so as to optimize color coordinates and/or a color combination. In particular, when an anti-reflection layer is included, there may be a limit in increasing an aperture ratio of each sub-pixel, due to a reflectance. One or more embodiments of the invention include a display panel and an electronic device for increasing a light-emission area of each sub-pixel arranged in a preset unit area of a display area.

The invention is defined by the features of the independent claims. The dependent claims describe preferred embodiments.

Additional aspects will be set forth in part in the description which follows and, in part, will be apparent from the description, or may be learned by practice of embodiments of the present invention.

According to one or more embodiments of the invention, a display panel includes a substrate including a display area, and a plurality of unit areas arranged on the substrate, the plurality of unit areas being adjacent to each other in the display area, wherein each of the plurality of unit areas includes a first display element, a second display element, and a third display element configured to emit light of different colors, the first display element, the second display element, and the third display element are arranged in each of the plurality of unit areas, the first display element includes a first distinguished display element in which a plan shape of an emission area is a polygon having a long side and a short side, and a second distinguished display element that is spaced from the first distinguished display element and in which a plan shape of an emission area is a polygon having a long side and a short side, and an arbitrary straight line extending from the long side, that is in the long side direction, of the plan shape of the emission area of the first distinguished display element is perpendicular to an arbitrary straight line extending from the long side, that is in the long side direction, of the plan shape of the emission area of the second distinguished display element. In other words, in a plan view onto the display elements in the unit area, the long side, that is the long side direction, of the polygon of the emission area of the first distinguished display element is perpendicularly to the long side, that is the long side direction, of the polygon of the display area of the second distinguished display element.

The first distinguished display element may also be termed as a first sub-display element of the first display element, and the second distinguished display element may also be termed as a second sub-display element of the first display element.

The unit areas of the plurality of unit areas may be arranged in a matrix form.

In one or more embodiments, the display panel may further include a plurality of sub-pixel circuits arranged in each of the plurality of unit areas, and connected to each of the first display element, the second display element, and the third display element, and one of the plurality of sub-pixel circuits may be concurrently connected to the first distinguished display element and the second distinguished display element.

In one or more embodiments, the first distinguished display element and the second distinguished display element may be configured to emit red light or green light.

In one or more embodiments, the plan shape of the emission area of the first distinguished display element and the plan shape of the emission area of the second distinguished display element may be a rectangular shape or an octagonal shape.

In one or more embodiments, when the first display element emits light, the first distinguished display element and the second distinguished display element may concurrently emit light a same color.

In one or more embodiments, a distance from an edge of a plan shape of an emission area of one of the second display element or the third display element, the one being adjacent to the long side of the first distinguished display element, that is the long side of the polygon of the emission area of the first distinguished display element, to the long side of the polygon of the emission area of the first distinguished display element may be equal to a distance from an edge of a plan shape of an emission area of the other one of the second display element and the third display element, the other one being adjacent to the short side of the first distinguished display element, that is the short side of the polygon of the emission area of the first distinguished display element, to the short side of the polygon of the emission area of the first distinguished display element.

In one or more embodiments, each of a center of the plan shape of the emission area of the first distinguished display element, a center of the plan shape of the emission area of the second distinguished display element, a center of a plan shape of an emission area of the second display element, and a center of a plan shape of an emission area of the third display element may be arranged at a vertex of a square.

In one or more embodiments, one of a center of the plan shape of the emission area of the first distinguished display element or a center of the plan shape of the emission area of the second distinguished display element and a center of a plan shape of an emission area of the second display element, which are arranged in each of the plurality of unit areas, may be arranged on a straight line.

In one or more embodiments, one of a center of the plan shape of the emission area of the first distinguished display element or a center of the plan shape of the emission area of the second distinguished display element and a center of a plan shape of an emission area of the third display element, which are arranged in each of the plurality of unit areas, may be arranged on a straight line.

In one or more embodiments, a center of the plan shape of the emission area of the first distinguished display element and a center of the plan shape of the emission area of the second distinguished display element may be arranged in a diagonal direction in each of the plurality of unit areas.

In one or more embodiments, a center of the plan shape of the emission area of the first distinguished display element and a center of the plan shape of the emission area of the second distinguished display element which are arranged in the display area may be arrayed in a serpentine shape, for example along a row direction and/or a column direction of the plurality of unit areas, when the unit areas are arranged adjacent to each other in a matrix form.

In one or more embodiments, a plan shape of an emission area of the third display element may be a square.

In one or more embodiments, a corner of the plan shape of the emission area of the third display element may be chamfered.

In one or more embodiments, the display panel may further include an anti-reflection layer on the first display element, the second display element, and the third display element, the anti-reflection layer including a color filter.

In one or more embodiments, when each of the first display element, the second display element, and the third display element having different aperture ratios is arranged in each of the plurality of unit areas, the first display element may have a smallest aperture ratio from among the first display element, the second display element, and the third display element arranged in each of the plurality of unit areas, and/or a difference between an aperture ratio of the first display element and an aperture ratio of one of the second display element, or the third display element, the one having a smallest aperture ratio, may be equal to or less than 10 %.

In one or more embodiments, one side of the plan shape of the emission area of the first distinguished display element and/or one side of the plan shape of the emission area of the second distinguished display element may be arranged within a distance between two parallel sides of the plan shape of the emission area of the second display element and/or arranged within a distance between two parallel sides of the plan shape of the emission area of the third display element.

According to one or more alternative embodiments of the invention, a display panel includes a substrate including a display area, and a plurality of unit areas arranged on the substrate, the plurality of unit areas being adjacent to each other in the display area, wherein each of the plurality of unit areas includes a first display element, a second display element, and a third display element configured to emit light of different colors, the first display element, the second display element, and the third display element are arranged in each unit area, the first display element includes a first distinguished display element in which a plan shape of an emission area is a circle or an oval, and a second distinguished display element that is arranged apart from the first distinguished display element and in which a plan shape of an emission area is a circle or an oval.

Again, the first distinguished display element may also be termed as a first sub-display element of the first display element, and the second distinguished display element may also be termed as a second sub-display element of the first display element.

The unit areas of the plurality of unit areas may be arranged in a matrix form.

In one or more embodiments, the display panel may further include a plurality of sub-pixel circuits arranged in each unit area, and connected to each of the first display element, the second display element, and the third display element, and one of the plurality of sub-pixel circuits may be simultaneously connected to the first distinguished display element and the second distinguished display element.

In one or more embodiments, the first distinguished display element and the second distinguished display element may emit red light or green light.

In one or more embodiments, when the first display element emits light, the first distinguished display element and the second distinguished display element may simultaneously emit light of a same color.

In one or more embodiments, a center of the plan shape of the emission area of the first distinguished display element, a center of the plan shape of the emission area of the second distinguished display element, a center of a plan shape of an emission area of the second display element, and a center of a plan shape of an emission area of the third display element may each be arranged at a vertex of a square.

In one or more embodiments, one of a center of the plan shape of the emission area of the first distinguished display element or a center of the plan shape of the emission area of the second distinguished display element and one of a center of a plan shape of an emission area of the second display element or a center of a plan shape of an emission area of the third display element, which are arranged in each unit area, may be arranged on a straight line.

In one or more embodiments, a center of the plan shape of the emission area of the first distinguished display element and a center of the plan shape of the emission area of the second distinguished display element may be arranged in a diagonal direction in each unit area.

In one or more embodiments, a center of the plan shape of the emission area of the first distinguished display element and a center of the plan shape of the emission area of the second distinguished display element which are arranged in the display area may be arrayed in a serpentine shape, for example along a row direction and/or a column direction of the plurality of unit areas, when the unit areas are arranged adjacent to each other in a matrix form.

In one or more embodiments, a plan shape of an emission area of one of the second display element or the third display element may be a circle or an oval.

In one or more embodiments, the display panel may further include an anti-reflection layer arranged on the first display element, the second display element, and the third display element, and including a color filter.

In one or more embodiments, when each of the first display element, the second display element, and the third display element which have different aperture ratios is arranged in each unit area, the first display element may have a smallest aperture ratio from among the first display element, the second display element, and the third display element arranged in each unit area, and/or a difference between an aperture ratio of the first display element and an aperture ratio of one of the second display element, and the third display element, the one having a smallest aperture ratio, may be equal to or less than 10 %.

In one or more embodiments, the plan shape of the emission area of the first distinguished display element and/or the plan shape of the emission area of the second distinguished display element may be arranged within an area formed by an arbitrary tangent line contacting a plan shape of an emission area of the second display element and an arbitrary tangent line contacting a plan shape of an emission area the third display element, the arbitrary tangent lines crossing each other and being parallel to an arbitrary straight line passing a center of the second display element or a center of the third display element arranged in adjacent unit areas. In other words, the plan shape of the emission area of the first distinguished display element and/or the plan shape of the emission area of the second distinguished display element may be arranged adjacent to the second display element in a first direction and adjacent to the third display element in a second direction which is perpendicular to the first direction within the same unit area.

According to one or more embodiments, an electronic device includes a display panel, wherein the display panel includes a substrate including a display area, and a plurality of unit areas arranged on the substrate, and arranged to be adjacent to each other in the display area, each unit area includes a first display element, a second display element, and a third display element which emit light of different colors, the first display element, the second display element, and the third display element are arranged in each unit area, the first display element includes a first distinguished display element in which a plan shape of an emission area is a polygon having a long side and a short side, and a second distinguished display element that is arranged apart from the first distinguished display element and in which a plan shape of an emission area is a polygon having a long side and a short side, and an arbitrary straight line extending from the long side, that is in the long side direction, of the plan shape of the emission area of the first distinguished display element is perpendicular to an arbitrary straight line extending from the long side, that is in the long side direction, of the plan shape of the emission area of the second distinguished display element. In other words, in a plan view onto the display elements in the unit area, the long side, that is the long side direction, of the polygon of the emission area of the first distinguished display element is perpendicularly to the long side, that is the long side direction, of the polygon of the display area of the second distinguished display element.

In one or more embodiments, the display panel may further include a plurality of sub-pixel circuits arranged in each unit area, and connected to each of the first display element, the second display element, and the third display element, and one of the plurality of sub-pixel circuits may be simultaneously connected to the first distinguished display element and the second distinguished display element.

In one or more embodiments, the plan shape of the emission area of the first distinguished display element and the plan shape of the emission area of the second distinguished display element may be a rectangular shape or an octagonal shape.

In one or more embodiments, a distance from an edge of a plan shape of an emission area of one of the second display element and the third display element, the one being adjacent to the long side of the first distinguished display element, that is the long side of the polygon of the emission area of the first distinguished display element, to the long side of the first distinguished display element, that is the long side of the polygon of the emission area of the first distinguished display element, may be equal to a distance from an edge of a plan shape of an emission area of the other one of the second display element and the third display element, the other one being adjacent to the short side of the first distinguished display element, that is the short side of the polygon of the emission area of the first distinguished display element, to the short side of the polygon of the emission area of the first distinguished display element.

In one or more embodiments, the display panel may further include an anti-reflection layer arranged on the first display element, the second display element, and the third display element, and including a color filter.

In one or more embodiments, when the first display element emits light, the first distinguished display element and the second distinguished display element may simultaneously emit light of a same color.

In one or more embodiments, when each of the first display element, the second display element, and the third display element which have different aperture ratios is arranged in each unit area, the first display element may have a smallest aperture ratio from among the first display element, the second display element, and the third display element arranged in each unit area, and/or a difference between an aperture ratio of the first display element and an aperture ratio of one of the second display element, and the third display element, the one having a smallest aperture ratio, may be equal to or less than 10 %.

In one or more embodiments, one side of the plan shape of the emission area of the first distinguished display element and/or one side of the plan shape of the emission area of the second distinguished display element may be arranged within a distance between two parallel sides of the plan shape of the emission area of the second display element and/or arranged within a distance between two parallel sides the plan shape of the emission area of the third display element.

According to one or more alternative embodiments of the invention, an electronic device includes a display panel, wherein the display panel includes a substrate including a display area, and a plurality of unit areas arranged on the substrate, and arranged to be adjacent to each other in the display area, each unit area includes a first display element, a second display element, and a third display element which emit light of different colors, the first display element, the second display element, and the third display element are arranged in each unit area, the first display element includes a first distinguished display element in which a plan shape of an emission area is a circle or an oval, and a second distinguished display element that is arranged apart from the first distinguished display element and in which a plan shape of an emission area is a circle or an oval. The first distinguished display element may also be termed as a first sub-display element of the first display element, and the second distinguished display element may also be termed as a second sub-display element of the first display element.

The unit areas of the plurality of unit areas may be arranged in a matrix form.

In one or more embodiments, the display panel may further include a plurality of sub-pixel circuits arranged in each unit area, and connected to each of the first display element, the second display element, and the third display element, and one of the plurality of sub-pixel circuits may be simultaneously connected to the first distinguished display element and the second distinguished display element.

In one or more embodiments, when the first display element emits light, the first distinguished display element and the second distinguished display element may simultaneously emit light of a same color.

In one or more embodiments, a center of the plan shape of the emission area of the first distinguished display element, a center of the plan shape of the emission area of the second distinguished display element, a center of a plan shape of an emission area of the second display element, and a center of a plan shape of an emission area of the third display element may each be arranged at a vertex of a square.

In one or more embodiments, a plan shape of an emission area of one of the second display element or the third display element may be a circle or an oval.

In one or more embodiments, the display panel may further include an anti-reflection layer arranged on the first display element, the second display element, and the third display element, and including a color filter.

In one or more embodiments, when each of the first display element, the second display element, and the third display element which have different aperture ratios is arranged in each unit area, the first display element may have a smallest aperture ratio from among the first display element, the second display element, and the third display element arranged in each unit area, and/or a difference between an aperture ratio of the first display element and an aperture ratio of one of the second display element, and the third display element, the one having a smallest aperture ratio, may be equal to or less than 10 %.

In one or more embodiments, the plan shape of the emission area of the first distinguished display element and/or the plan shape of the emission area of the second distinguished display element may be arranged within an area formed by an arbitrary tangent line contacting a plan shape of an emission area of the second display element and an arbitrary tangent line contacting a plan shape of an emission area the third display element, the arbitrary tangent lines crossing each other and being parallel to an arbitrary straight line passing a center of the second display element or a center of the third display element arranged in adjacent unit areas. In other words, the plan shape of the emission area of the first distinguished display element and/or the plan shape of the emission area of the second distinguished display element may be arranged adjacent to the second display element in a first direction and adjacent to the third display element in a second direction which is perpendicular to the first direction within the same unit area.

Other aspects, features, and advantages of the invention will become more apparent from the drawings, the claims, and the detailed description.

The above and other aspects and features of embodiments of the present invention will be more apparent from the following description taken in conjunction with the accompanying drawings, in which:
FIG. 1 is a block diagram of an electronic device according to one or more embodiments;
FIGS. 2 - 4 are schematic diagrams of an electronic device according to one or more embodiments of the invention;
FIG. 5 is a perspective view schematically illustrating an electronic device according to one or more embodiments of the invention;
FIG. 6 is an exploded perspective view schematically illustrating the electronic device of FIG. 5;
FIG. 7A is a plan view schematically illustrating a portion of a display apparatus shown in FIG. 6;
FIG. 7B is a side view schematically illustrating a portion of a display apparatus shown in FIG. 7A;
FIG. 8 is a plan view schematically illustrating a portion of the display apparatus shown in FIG. 6;
FIG. 9 is a circuit diagram schematically illustrating a sub-pixel circuit of a sub-pixel arranged in a display area shown in FIG. 8;
FIG. 10A is a cross-sectional view schematically illustrating a portion of the display apparatus shown in FIG. 6;
FIG. 10B is a cross-sectional view of a display panel, an adhesive layer and a cover window, taken along the line B-B' of FIG. 8;
FIG. 10C is a cross-sectional view of the display panel, an adhesive layer and a cover window, taken along the line B-B' of FIG. 8;
FIGS. 11A and 11B are plan views schematically illustrating a display area of a display panel of FIG. 6;
FIGS. 12A and 12B are cross-sectional views schematically illustrating a portion of a display panel, taken along the line C-C' of FIG. 11A;
FIG. 13A is a cross-sectional view schematically illustrating a manufacturing apparatus of a display panel according to one or more embodiments of the invention;
FIG. 13B is a plan view schematically illustrating a mask assembly shown in FIG. 13A;
FIG. 13C is a plan view illustrating a portion of a mask sheet for the manufacture of a comparative example with respect to the present invention;
FIG. 13D is a plan view illustrating a portion of a display panel manufactured by a scheme shown in FIG. 13C;
FIG. 13E is a plan view illustrating a portion of a mask sheet for the manufacture of a comparative example with respect to the present invention;
FIG. 13F is a plan view illustrating a portion of a display panel manufactured by a scheme shown in FIG. 13E;
FIG. 14 is a plan view schematically illustrating a unit area of a display area of a display panel according to one or more embodiments of the invention;
FIG. 15 is a plan view schematically illustrating a display area of a display panel according to one or more embodiments of the invention;
FIG. 16 is a plan view schematically illustrating a display area of a display panel according to one or more embodiments of the invention; and
FIG. 17 is a plan view schematically illustrating a display area of a display panel according to one or more embodiments of the invention.

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects and features of embodiments of the present invention. As used herein, the term "and/or" includes any and all combinations of one or more of the associated listed items. Throughout the present disclosure, the expression "at least one of a, b or c" indicates only a, only b, only c, both a and b, both a and c, both b and c, all of a, b, and c, or variations thereof.

As the present invention allows for various changes and numerous embodiments, particular embodiments will be illustrated in the drawings and described in the detailed description. Effects, aspects, and features of embodiments of the present invention, and methods for achieving them will be clarified with reference to embodiments described below in detail with reference to the drawings. However, the present invention is not limited to the following embodiments and may be embodied in various forms.

Hereinafter, embodiments will be described in detail with reference to the accompanying drawings, wherein the same or corresponding elements are denoted by the same reference numerals throughout and redundant descriptions thereof are omitted.

Although the terms "first," "second," etc. may be used to describe various elements, these elements should not be limited by these terms. These terms are only used to distinguish one element from another.

As used herein, the singular forms "a," "an," and "the" are intended to include the plural forms as well, unless the context clearly indicates otherwise.

It will be further understood that the terms "comprise" or "including" used herein specify the presence of stated features or elements, but do not preclude the presence or addition of one or more other features or elements.

It will be further understood that, when a layer, region, or element is referred to as being "on" another layer, region, or element, it may be directly on the other layer, region, or element, or may be indirectly on the other layer, region, or element with intervening layers, regions, or elements therebetween.

Sizes of elements in the drawings may be exaggerated or reduced for convenience of descriptions. For example, as sizes and thicknesses of elements in the drawings are arbitrarily illustrated for convenience of descriptions, the present invention is not limited thereto.

In the following embodiments, the x-axis, the y-axis and the z-axis are not limited to three axes of the rectangular coordinate system and may be interpreted in a broader sense. For example, the x-axis, the y-axis, and the z-axis may be perpendicular to one another or may represent different directions that are not perpendicular to one another.

When a certain embodiment may be implemented differently, a particular process order may be different from the described order. For example, two consecutively described processes may be substantially concurrently (e.g., simultaneously) performed, or may be performed in an order opposite to the described order.

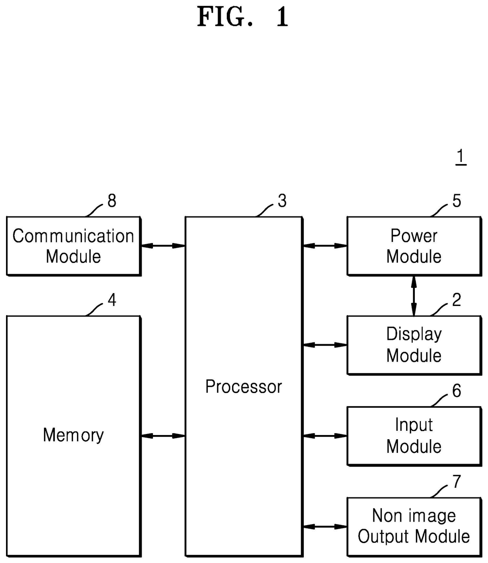

FIG. 1 is a block diagram of an electronic device 1 according to one or more embodiments.

Referring to FIG. 1, the electronic device 1 according to one or more embodiments may include a display module 2 including a display panel, a processor 3, a memory 4, and a power module 5.

The processor 3 may include at least one of a central processing unit (CPU), an application processor (AP), a graphic processing unit (GPU), a communication processor (CP), an image signal processor (ISP), or a controller. In one or more embodiments, the processor 3 may be provided by being functionally or structurally divided into at least two processors. For example, the processor 3 may include a main processor in the form of a first driving chip including a CPU, and an auxiliary processor in the form of a second driving chip including a controller configured to receive an image signal from the main processor and process the image signal to be adapted to an interface specification of the display module 2.

The memory 4 may include at least one of a non-volatile memory or a volatile memory. The memory 4 may store data information required for an operation of the processor 3 or the display module 2. When the processor 3 executes an application stored in the memory 4, an image data signal and/or an input control signal may be transmitted to the display module 2, and the display module 2 may process the provided signal, and thus, may output image information via a display screen.

The power module 5 may include a power supply module such as a power adaptor and/or a battery device, and a power conversion module for generating, by converting power supplied by the power supply module, power required for an operation of the electronic device 1. Power conversion by the power conversion module may include, but is not limited to, direct current (DC)-DC conversion, alternating current (AC)-DC conversion, and DC-AC conversion.

The electronic device 1 may further include an input module 6, a non-image output module 7, and/or a communication module 8.

The input module 6 may provide input information to the processor 3 and/or the display module 2. The input module 6 may include not only physical buttons, a keyboard, and/or a microphone but also include various sensor modules. An example of a sensor module may include not only a touch sensor, a pressure sensor, a distance sensor, a position sensor, a digitizer, a motion recognition sensor, a camera sensor, a light-receiving sensor, a photoelectric conversion sensor, and a temperature sensor but also include a biometric sensor including a blood pressure sensor, a blood glucose sensor, an electrocardiogram sensor, a heart rate sensor, etc.

The non-image output module 7 may provide a user with information by receiving the information other than an image transmitted from the processor 3. An example of the non-image output module 7 may include an audio module, a haptic module, a light-emitting module, etc., and may also include other intrinsic functional module (e.g., a cooling module of a refrigerator) of an electronic device 1.

The communication module 8 is a module to handle information transmission and reception between the electronic device 1 and an external device, and may include a receiver and a transmitter. The communication module 8 may include various wireless communication modules including a mobile communication module, a wireless-fidelity (Wi-Fi) module, a Bluetooth module, etc., and/or various wired communication modules.

At least one of elements of the electronic device 1 may be included in a display apparatus according to aforementioned embodiments. Also, some of separate modules functionally included in the electronic device 1 may be included in the display apparatus, and others may be provided separately from the display apparatus. For example, the display apparatus may include the display module 2, and the processor 3, the memory 4, and the power module 5 may be provided in the form of other devices in the electronic device 1, not in the display apparatus. As another example, the power module 5 may be arranged in the display apparatus, and may provide power to the processor 3 and the memory 4 arranged in the electronic device 1, not in the display apparatus, but the present invention is not limited thereto.

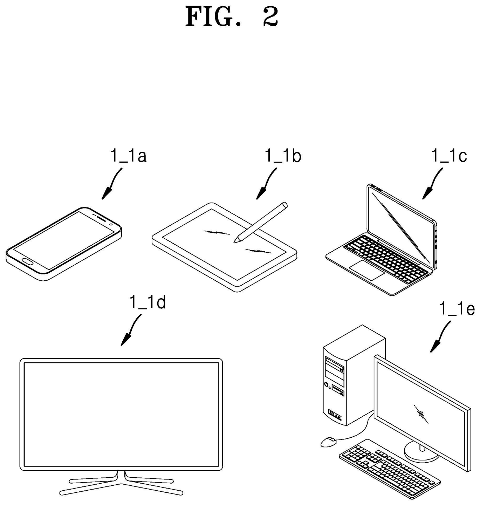

FIGS. 2 - 4 are schematic diagrams of an electronic device according to various embodiments. FIGS. 2 - 4 illustrate examples of various electronic devices to which display apparatuses according to one or more embodiments are applied.

FIG. 2 illustrates a smartphone 1_1a, a tablet personal computer (PC) 1_1b, a laptop computer 1_1c, a television (TV) 1_1d, and a monitor for desk 1_1e.

The smartphone 1_1a may include an input module including a touch sensor, and a communication module, as well as the display module 2. The smartphone 1_1a may process information received via the communication module or another input module, and thus, may display the information via a display module of a display apparatus.

Similar to the smartphone 1_1a, each of the tablet PC 1_1b, the laptop computer 1_1c, the TV 1_1d, and the monitor for desk 1_1e may include a display module and an input module, and, in some cases, may further include a communication module.

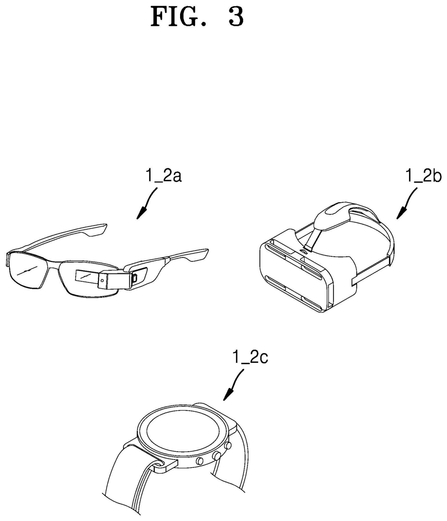

FIG. 3 illustrates an example in which an electronic device including a display module is applied to a wearable electronic device. The wearable electronic device may include smart glasses 1_2a, a head-mounted display 1_2b, a smart watch 1_2c, or the like.

Each of the smart glasses 1_2a and the head-mounted display 1_2b may include a display module for projecting a display image, and a reflector for reflecting a projected display screen and providing the reflected display screen to eyes of a user, and thus, may provide the user with an image of a virtual reality or an augmented reality.

The smart watch 1_2c may include a biometric sensor as an input device, and may provide, via a display module, a user with biometric information recognized via the biometric sensor.

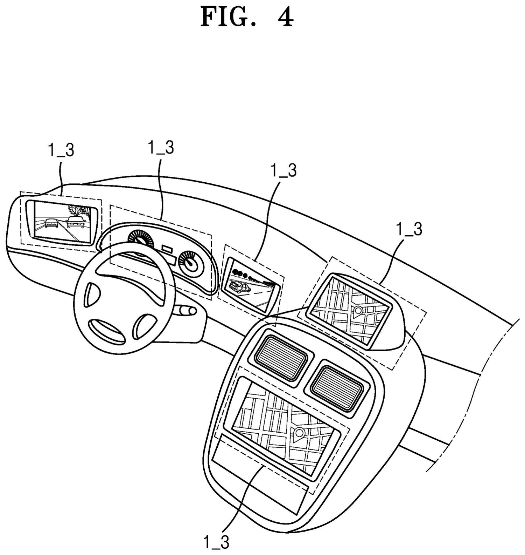

FIG. 4 illustrates an example in which an electronic device 1_3 including a display module is applied to a vehicle. For example, the electronic device 1_3 may be applied to a dashboard, a center console, etc. of the vehicle, or may be applied to a center information display (CID) arranged on the dashboard of the vehicle, a room mirror display replacing a side-view mirror of the vehicle, etc.

In one or more embodiments, an electronic device to which a display apparatus according to one or more embodiments is applied may include not only devices including an advertisement board, an electronic display board, a game player, etc. for mainly displaying an image but also include various home appliances including a refrigerator, a washing machine, a dryer, an air conditioner, a robot cleaner, etc. for displaying information via a display module. Also, when a display module has a function for transmitting light, the display module may be applied to a smart window, or an electronic device including a transparent display apparatus that displays both a background and a display image. Types of an electronic device according to one or more embodiments are not limited to the examples, and application to other unstated various electronic devices may be possible.

Hereinafter, for convenience of descriptions, a case in which the electronic device 1 is a smartphone will be mainly described.

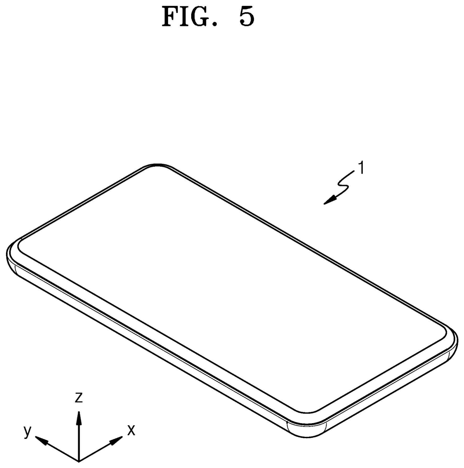

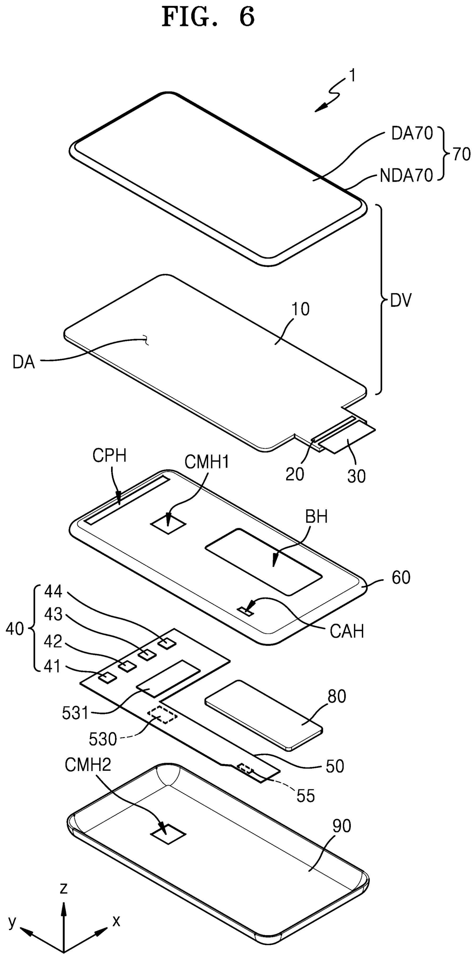

FIG. 5 is a perspective view schematically illustrating the electronic device 1 according to one or more embodiments. FIG. 6 is an exploded perspective view schematically illustrating the electronic device 1 of FIG. 5.

Referring to FIGS. 5 and 6, the electronic device 1 may include a display apparatus DV including a cover window 70, a display panel 10, a data driver 20, and a display circuit board 30, a bracket 60, a main circuit board 50, a battery 80, and/or a lower cover 90.

In the specification, "left," "right," "upper," and "lower" in a plan view refer to directions when the display panel 10 is viewed in a direction perpendicular to the display panel 10. For example, "left" refers to a -x direction, "right" refers to a +x direction, "upper" refers to a +y direction, and "lower" refers to a -y direction.

In a plan view, the electronic device 1 may have a substantially rectangular shape. For example, the electronic device 1 may have a substantially rectangular shape having a short side in an x-axis direction and a long side in a y-axis direction in a xy plane as shown in FIG. 5. In this case, a corner where the short side in the x-axis direction and the long side in the y-axis direction meet each other may form a right angle or may have a rounded shape with a preset curvature. However, in a plan view, the electronic device 1 may have a polygonal shape other than a rectangular shape, may have an elliptical shape, or an irregular shape.

The cover window 70 may be arranged on the display panel 10 so as to cover a top surface of the display panel 10. The cover window 70 may protect the top surface of the display panel 10.

The cover window 70 may include a transmissive cover portion DA70 corresponding to the display panel 10 and a light-blocking cover portion NDA70 around (e.g., surrounding) the transmissive cover portion DA70. The light-blocking cover portion NDA70 may include an opaque material for blocking light (e.g., a colored opaque material). The light-blocking cover portion NDA70 may include a pattern that may be shown to a user when an image is not displayed.

The display panel 10 may be arranged under the cover window 70. The display panel 10 may overlap the transmissive cover portion DA70 of the cover window 70. The display panel 10 includes a display area DA. The display area DA where an image is displayed may include an area (hereinafter, referred to as a component area) where light emitted from the component 40 arranged under the display panel 10 is transmitted. The component may include a sensor or a camera using visible light, infrared light, and/or sound.

The display panel 10 may be a light-emitting display panel including a light-emitting diode. The light-emitting diode may be an organic light-emitting diode (OLED) including an emission layer, or an inorganic light-emitting diode including an inorganic material. The inorganic light-emitting diode may include a PN junction diode including inorganic semiconductor-based materials. When a voltage is applied to a PN junction diode in a forward direction, holes and electrons may be injected, and energy generated by recombination of the holes and electrons may be converted into light energy to emit light of suitable color (e.g., a preset color). The inorganic light-emitting diode may have a width of several micrometers to hundreds of micrometers. The inorganic light-emitting diode may be referred to as a micro LED.

The display panel 10 may be a rigid display panel that is rigid and is not easily bent, or a flexible display panel that is flexible and may be easily bent, folded, and/or rolled. For example, the display panel 10 may be a foldable display panel that may be folded and/or unfolded, a curved display panel with a curved display surface, a bended display panel with a bended area other than a display surface, a rollable display panel that may be rolled and/or unrolled, or a stretchable display panel.

The display panel 10 may be a transparent display panel that is transparent so that an object or a background arranged on a bottom surface of the display panel 10 is viewed from the top surface of the display panel 10. Alternatively, the display panel 10 may be a reflective display panel capable of reflecting an object or a background on the top surface of the display panel 10.

The data driver 20 may be mounted on the display panel 10 in the form of an integrated circuit (IC). However, the present invention is not limited thereto, and for example, the data driver 20 may be mounted on the display circuit board 30.

The display circuit board 30 may be attached to one side of the display panel 10. The display circuit board 30 may be a flexible printed circuit board (FPCB) that is bendable, a rigid printed circuit board (PCB) that is rigid and is not bendable, or a composite printed circuit board including both the rigid PCB and the FPCB. A touch sensor driver may be mounted on the display circuit board 30. The touch sensor driver may be formed as an integrated circuit (IC). The touch sensor driver may be electrically connected to touch electrodes of a touchscreen layer of the display panel 10 via the display circuit board 30.

The touchscreen layer of the display panel 10 may detect a touch input of the user by using at least one of various touch methods such as a resistive method and/or a capacitive method. When the touchscreen layer of the display panel 10 detects a touch input of the user by using a capacitive method, the touch sensor driver may apply driving signals to driving electrodes from among the touch electrodes, and may determine whether the user touches by detecting voltages charged in mutual capacitances (hereinafter referred to as "mutual capacitance") between the driving electrodes and sensing electrodes via the sensing electrodes from among the touch electrodes.

A user's touch may include a contact touch and a proximity touch. The contact touch means that an object such as a user's finger or a pen directly contacts the cover window 70 arranged on the touchscreen layer. The proximity touch means that an object such as the user's finger or a pen is located close to the cover window 70, such as hovering. The touch sensor driver may transmit sensor data to a main processor 530 according to the detected voltages, and the main processor 530 may calculate touch coordinates where the touch input occurs by analyzing the sensor data.

A controller for supplying driving voltages for driving pixels of the display panel 10, a gate driver, and/or the data driver 20 may be arranged on the display circuit board 30.

The bracket 60 for supporting the display panel 10 may be arranged under the display panel 10. The bracket 60 may include plastic, metal, or both plastic and metal. The bracket 60 may include a first camera hole CMH1 into which a camera device 531 is inserted, a battery hole BH in which the battery 80 is arranged, a cable hole CAH through which a cable connected to the display circuit board 30 passes, and a component hole CPH corresponding to the components 40. The component hole CPH may overlap the components 40 of the main circuit board 50 when viewed in a third direction (a z-axis direction). For reference, the display area DA of the display panel 10 may overlap the components 40 of the main circuit board 50 when viewed in the third direction (the z-axis direction). When necessary, the bracket 60 may not have the component hole CPH.

The components 40 included in the electronic device 1 may include a first component 41, a second component 42, a third component 43, and a fourth component 44 overlapping the display panel 10. Each of the first component 41, the second component 42, the third component 43, and the fourth component 44 may include at least one of a proximity sensor, an illumination sensor, an iris sensor, a facial recognition sensor, and/or a camera (or an image sensor). The proximity sensor using infrared rays may detect an object located close to a top surface of the electronic device 1, and the illuminance sensor may detect a brightness of light incident on the top surface of the electronic device 1. Also, the iris sensor may capture an image of the iris of a person located over the top surface of the electronic device 1, and the camera may obtain image data of the object arranged over the top surface of the electronic device 1. The component 40 is not limited to the proximity sensor, the illumination sensor, the iris sensor, the facial recognition sensor, and/or the camera, and may include another sensor.

The main circuit board 50 and the battery 80 may be disposed under the bracket 60. The main circuit board 50 may be a rigid printed circuit board (PCB) or a flexible printed circuit board (FPCB).

The main circuit board 50 may include the main processor 530, the camera device 531, a main connector 55, and the components 40. The main processor 530 may be formed as an integrated circuit (IC). When necessary, the electronic device 1 may include not only the camera device 531 arranged on a top surface of the main circuit board 50 but also a camera device arranged on a bottom surface of the main circuit board 50. Each of the main processor 530 and the main connector 55 may be arranged on one of the top surface or the bottom surface of the main circuit board 50. The main circuit board 50 may be electrically connected to the display circuit board 30 via the main connector 55 and/or the like.

The main processor 530 may control all functions of the electronic device 1. For example, the main processor 530 may output digital video data to the data driver 20 via the display circuit board 30 so that the display panel 10 displays an image. The main processor may 530 receive detection data from the touch sensor driver. The main processor 530 may determine whether the user touches according to the detection data, and may perform an operation corresponding to the user's direct touch(i.e., contact touch) or proximity touch. The main processor 530 may be an application processor, a central processing unit (CPU), or a system chip formed as an integrated circuit (IC).

The camera device 531 processes an image frame such as a still image and/or a moving image obtained by an image sensor in a camera mode and outputs the image frame to the main processor 530. The camera device 531 may include at least one of a camera sensor (e.g., charge-coupled device (CCD) or complementary metal-oxide-semiconductor (CMOS)), a photo sensor (or image sensor), or a laser sensor.

A cable passing through the cable hole CAH of the bracket 60 may be connected to the main connector 55, and the main circuit board 50 may be electrically connected to the display circuit board 30 via the cable.

The electronic device 1 may include, a wireless communication unit, an input unit, a sensor unit, an output unit, an interface unit, a memory, and/or a power supply unit, in addition to the main processor 530.

The wireless communication unit may include at least one of a broadcast receiving module, a mobile communication module, a wireless Internet module, a short-range communication module, or a location information module.

The broadcast receiving module receives a broadcast signal and/or broadcast-related information from an external broadcast management server via a broadcast channel. The broadcast channel may include a satellite channel and a terrestrial channel.

The mobile communication module transmits and receives a wireless signal to and from at least one of a base station, an external terminal, or a server in a mobile communication network established according to technical standards or communication methods for mobile communication (e.g., global system for mobile communication (GSM), code division multi-access (CDMA), code division multi-access 2000 (CDMA2000), enhanced voice-data optimized or enhanced voice-data only (EV-DO), wideband CDMA (WCDMA), high speed downlink packet access (HSDPA), high speed uplink packet access (HSUPA), long term evolution (LTE), and/or long term evolution-advanced (LTE-A)). The wireless signal may include various types of data according to transmission and reception of a voice call signal, a video call signal, and/or a text/multimedia message.

The wireless Internet module refers to a module for wireless Internet access. The wireless Internet module may be configured to transmit and/or receive a wireless signal in a communication network according to wireless Internet technology. The wireless Internet technology may be, for example, wireless LAN (WLAN), Wi-Fi, Wi-Fi direct, and/or digital living network alliance (DLNA).

The short-range communication module for short-range communication may support short-range communication by using at least one of Bluetooth^{™}, radio frequency identification (RFID), infrared data association (IrDA), ultra-wideband (UWB), ZigBee, near field communication (NFC), Wi-Fi, Wi-Fi direct, and wireless universal serial bus (USB) technology. The short-range communication module may support wireless communication between the electronic device 1 and a wireless communication system, between the electronic device 1 and another electronic device, or between the electronic device 1 and a network in which another electronic device (or an external server) is located via a wireless area network. The wireless area network may correspond to wireless personal area networks. The other electronic device may be a wearable device that may exchange data (or interoperate) with the electronic device 1.

The location information module for obtaining a location of the electronic device 1 may include a global positioning system (GPS) module or a Wi-Fi module.

The input unit may include an image input unit such as the camera device for inputting an image signal, a sound input unit such as a microphone for inputting a sound signal, and an input device for receiving information from the user. The camera device processes an image frame such as a still image /or a moving image obtained by the image sensor in a video call mode and/or a photographing mode. The processed image frame may be displayed on the display panel 10 or may be stored in the memory. The microphone processes an external sound signal into electrical voice data. The processed voice data may be used in various ways according to a function being performed (or an application being executed) in the electronic device 1.

The main processor 530 may control an operation of the electronic device 1, in response to information input via the input device. The input device may include a mechanical input means and/or a touch input means such as a button, a dome switch, a jog wheel, and/or a jog switch located on a rear surface or a side surface of the electronic device 1. The touch input means may include the touchscreen layer of the display panel 10.

The sensor unit may include one or more sensors that sense at least one of information in the electronic device 1, environment information surrounding the electronic device 1, or user information, and generates a corresponding sensing signal. The main processor 530 may control the driving or operation of the electronic device 1 or may perform data processing, a function, and/or an operation related to an application installed in the electronic device 1. The sensor unit may be a proximity sensor, an illumination sensor, and/or a facial recognition sensor as described with respect to the component 40. The sensor unit may include an acceleration sensor, a magnetic sensor, a Gravity sensor (G-sensor), a gyroscope sensor, a motion sensor, an RGB sensor, an infrared (IR) sensor, a finger scan sensor, an ultrasonic sensor, an optical sensor, and/or a battery gauge. In addition, the sensor unit may include an environmental sensor and/or a chemical sensor. The environmental sensor may be, for example, a barometer, a hygrometer, a thermometer, a radiation detection sensor, a heat detection sensor, and/or a gas detection sensor. The chemical sensor may be, for example, an electronic nose, a healthcare sensor, and/or a biometric sensor.

The output unit for generating an output related to visual, auditory, or tactile sense may include at least one of the display panel 10, a sound output unit, a haptic module, and/or a light output unit.

The display panel 10 displays (outputs) information processed by the electronic device 1. For example, the display panel 10 may display execution screen information of an application running on the electronic device 1, may display a user interface (UI) according to the execution screen information, or may display graphical user interface (GUI) information. The display panel 10 may include a display layer for displaying an image and/or a touchscreen layer for detecting a touch input of the user. Accordingly, the display panel 10 may function as one of input devices that provide an input interface between the electronic device 1 and the user and at the same time, may also function as one of output units that provide an output interface between the electronic device 1 and the user.

The sound output unit may output sound data received from the wireless communication unit or stored in the memory, in a call signal reception mode, a call mode, a recording mode, a voice recognition mode, and/or a broadcast reception mode. The sound output unit may output a sound signal related to a function (e.g., a call signal reception sound and/or a message reception sound) performed in the electronic device 1. The sound output unit may include a receiver and/or a speaker. At least one of the receiver or the speaker may be a sound generating device that is attached to the bottom of the display panel 10 and outputs sound by vibrating the display panel 10. The sound generating device may be a piezoelectric element and/or a piezoelectric actuator that contracts and/or expands according to an electrical signal, or an exciter that generates a magnetic force by using a voice coil and vibrates the display panel 10.

The haptic module generates various tactile effects that the user may feel. The haptic module may provide vibration to the user as a tactile effect. The haptic module may not only transfer a tactile effect through a direct contact, but may also allow the user to feel a tactile effect through a muscle sense such as a finger and/or arm of the user.

The light output unit outputs a signal for notifying the occurrence of an event by using light of a light source. Examples of events occurring in the electronic device 1 may include message reception, call signal reception, missed call, alarm, schedule notification, email reception, and/or information reception via an application. A signal output from the light output unit is implemented as the electronic device 1 emits light of a single color or multiple colors from a front surface or a rear surface. The signal output may be ended when the electronic device 1 detects that the user has checked the event.

The interface unit functions as a passage with various types of external devices connected to the electronic device 1. The interface unit may include at least one of a wired/wireless headset port, an external charger port, a wired/wireless data port, a memory card port, a port for connecting a device including an identification module, an audio input/output (I/O) port, a video I/O port, or an earphone port. When an external device is connected to the interface unit, the electronic device 1 may perform appropriate control related to the connected external device.

The memory stores data that supports various functions of the electronic device 1. The memory may store a plurality of applications (application programs) driven in the electronic device 1 and a plurality of pieces of data and/or instructions for an operation of the electronic device 1. At least some of the plurality of applications may be downloaded from an external server via wireless communication. The memory may store an application for an operation of the main processor 530, and may temporarily store input/output data, for example, a phone book, a message, a still image, and/or a moving image. Also, the memory may store haptic data for vibration of various patterns provided to the haptic module and/or sound data related to various sounds provided to the sound output unit.

The memory may include at least one type of storage medium from among a flash memory type, a hard disk type, a solid state disk (SSD) type, a silicon disk drive (SDD) type, a multimedia card micro type, a card type memory (e.g., SD or XD memory), an random-access memory (RAM), a static random-access memory (SRAM), a read-only memory (ROM), an electrically erasable programmable read-only memory (EEPROM), a programmable read-only memory (PROM), a magnetic memory, a magnetic disk, and an optical disk.

The power supply unit receives external power and/or internal power and supplies the power to each element included in the electronic device 1, under the control of the main processor 530. The power supply unit may include the battery 80. Also, the power supply unit may include a connection port, and the connection port may be an example of the interface unit to which an external charger for supplying power is electrically connected to charge the battery 80. Alternatively, the power supply unit may charge the battery 80 in a wireless manner. The battery 80 may be arranged so as not to overlap the main circuit board 50 in the third direction (z direction). The battery 80 may overlap the battery hole BH of the bracket 60.

The lower cover 90 may form an outer appearance of the electronic device 1 and may have an opening through which a part of the display panel 10 is exposed. The lower cover 90 has a shape whose surface corresponding to the display panel 10 is open and may be coupled to the display panel 10. The lower cover 90 may be located opposite to the cover window 70 with the display panel 10 therebetween. The lower cover 90 may be arranged under the main circuit board 50 and the battery 80. The lower cover 90 may be coupled and fixed to the bracket 60. The lower cover 90 may form an outer appearance of a bottom surface of the electronic device 1. The lower cover 90 may include plastic, metal, or both plastic and metal.

A second camera hole CMH2 through which a bottom surface of the camera device 531 is exposed may be formed in the lower cover 90. A position of the camera device 531, and positions of the first camera hole CMH1 and the second camera hole CMH2 corresponding to the camera device 531 are not limited to those illustrated in FIG. 6 and may be changed in various manners.

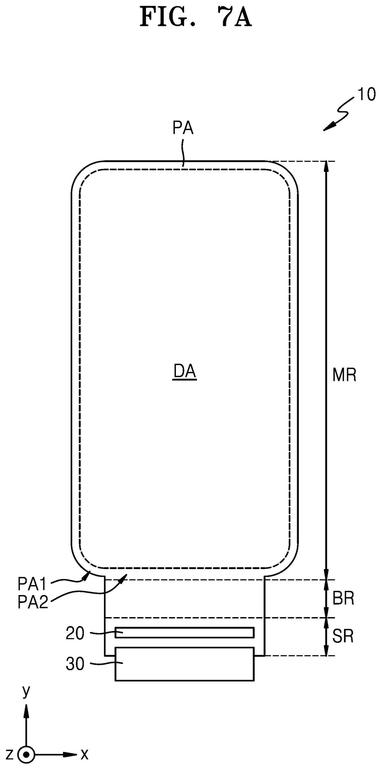

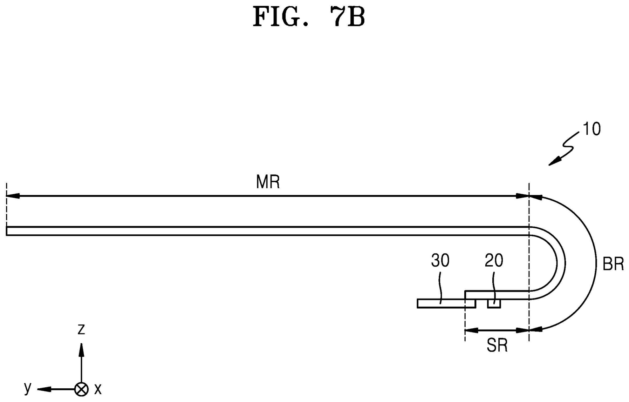

FIG. 7A is a plan view schematically illustrating a portion of the display apparatus shown in FIG. 6. FIG. 7B is a side view schematically illustrating a portion of the display apparatus shown in FIG. 7A. The electronic device 1 may include the portions of the display apparatus as shown in FIGS. 7A and 7B.

Referring to FIGS. 7A and 7B, the display panel 10 may include the display area DA and a peripheral area PA outside the display area DA along an edge or a periphery of the display area DA. The display area DA is a portion where an image is displayed, and a plurality of pixels may be arranged in the display area DA. The display area DA may have any of various shapes such as a circular shape, an elliptical shape, a polygonal shape, or a shape of a particular figure. In FIG. 7A, the display area DA has a substantially rectangular shape with rounded corners.

The peripheral area PA may be located outside the display area DA. The peripheral area PA may include a first peripheral area PA1 around (e.g., surrounding) at least a part of the display area DA and a second peripheral area PA2 located at a lower end of the display area DA and extending in a first direction (x-axis direction). A width of the second peripheral area PA2 in the first direction (the x-axis direction) may be less than a width of the display area DA in the first direction (the x-axis direction). With this structure, at least a part of the second peripheral area PA2 may be easily bent.

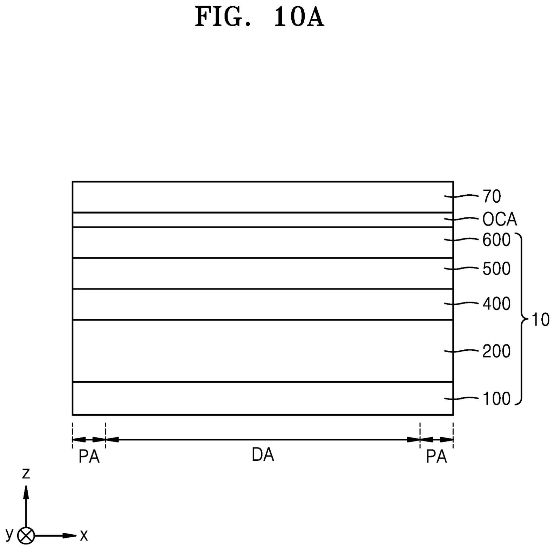

A planar shape of the display panel 10 of FIG. 7A may be substantially the same as a shape of a substrate 100 (e.g., see FIG. 10A) included in the display panel 10. When the display panel 10 includes the display area DA and the peripheral area PA outside the display area DA, it may mean that the substrate 100 includes the display area DA and the peripheral area PA outside the display area DA. For convenience, it will be described that the substrate 100 includes the display area DA and the peripheral area PA.

The display panel 10 may include a main region MR, a bending region BR outside the main region MR, and a sub-region SR spaced (e.g., spaced apart) from the main region MR with the bending region BR therebetween. The main region MR may be arranged on one side of the bending region BR, and the sub-region SR may be arranged on the other side of the bending region BR. The display panel 10 may be bent in the bending region BR as shown in FIG. 7B, and at least a part of the sub-region SR may overlap the main region MR when viewed in the third direction (z-axis direction). Although FIG. 7B illustrates that the display panel 10 is bent, the present invention is not limited thereto. For example, the display panel 10 may be a foldable display panel, and in this case, the display panel 10 may be bent in the display area DA around a bending axis crossing the display area DA. However, when necessary, the display panel 10 may not be bent. The sub-region SR may be a non-display area.

The data driver 20 may be arranged in the sub-region SR of the display panel 10. The data driver 20 may be arranged on the display panel 10 in the form of an integrated circuit (IC). For example, the data driver 20 may be a data driving integrated circuit (IC) that generates a data signal.

The display circuit board 30 may be attached to an end portion of the sub-region SR of the display panel 10. The display circuit board 30 may be electrically connected to the data driver 20 and/or the like via a pad of the sub-region SR of the display panel 10.

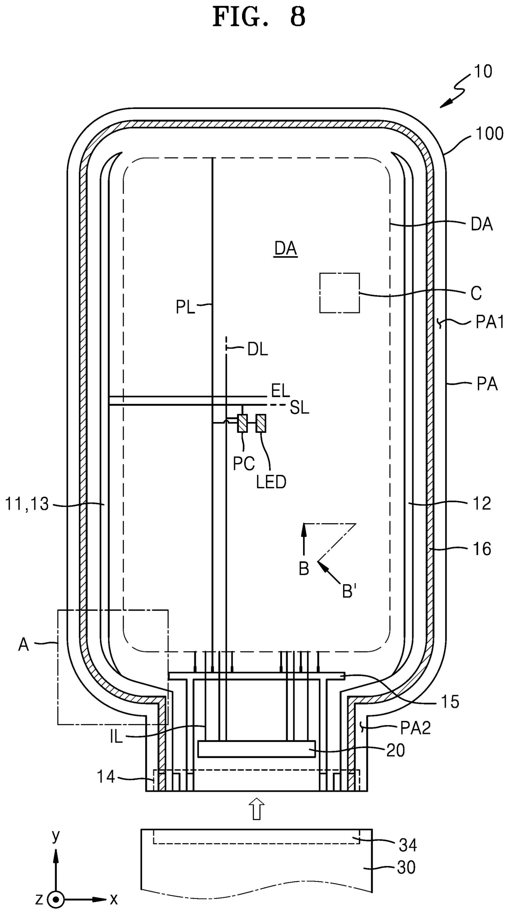

FIG. 8 is a plan view schematically illustrating a portion of the display apparatus shown in FIG. 6.

Referring to FIG. 8, the display panel 10 may include the substrate 100. Various elements included in the display panel 10 may be arranged on the substrate 100.

The substrate 100 may include glass, ceramic, metal, and/or polymer resin. The substrate 100 may include a polymer resin such as polyethersulfone, polyacrylate, polyetherimide, polyethylene naphthalate, polyethylene terephthalate, polyphenylene sulfide, polyarylate, polyimide, polycarbonate, and/or cellulose acetate propionate. The substrate 100 may have a multilayer structure including two layers including the polymer resin and an inorganic layer arranged between the two layers. Alternatively, the substrate 100 may have a structure in which layers including the polymer resin and inorganic layers are alternately stacked. The inorganic layer may include, for example, silicon oxide, silicon nitride, and/or silicon oxynitride.

Sub-pixels may be arranged in the display area DA, and the display area DA may provide an image by using light emitted from the sub-pixels. Each sub-pixel may include a light-emitting diode LED that is a display element, and the light-emitting diode LED may be electrically connected to a sub-pixel circuit PC. The sub-pixel circuit PC and the light-emitting diode LED may be arranged in the display area DA. For convenience, the sub-pixel circuit PC and the light-emitting diode LED are located in parallel (e.g., adjacent each other) in FIG. 8, but, actually, the sub-pixel circuit PC and the light-emitting diode LED may at least partially overlap each other. For example, the light-emitting diode LED may be arranged on the sub-pixel circuit PC.

A gate driving circuit, a pad 14, a first power supply wiring 15, and a second power supply wiring 16 may be arranged in the peripheral area PA. The gate driving circuit may include, for example, a first scan driving circuit 11, a second scan driving circuit 12, and/or an emission control driving circuit 13.

The first scan driving circuit 11 may provide a scan signal to the sub-pixel circuit PC via a scan line SL. The second scan driving circuit 12 may be arranged opposite to the first scan driving circuit 11 with the display area DA therebetween. Some of the sub-pixel circuits PC arranged in the display area DA may be electrically connected to the first scan driving circuit 11, and others may be connected to the second scan driving circuit 12. When necessary, the second scan driving circuit 12 may be omitted.

The emission control driving circuit 13 may be arranged on one side of the display area DA, as the first scan driving circuit 11. The emission control driving circuit 13 may provide an emission control signal to a pixel via the emission control line EL. Referring to FIG. 8, it is illustrated that the emission control driving circuit 13 is arranged only on one side of the display area DA, but the present invention is not limited thereto. For example, the display panel 10 may include the emission control driving circuits 13 arranged on one side and the other side of the display area DA. Alternatively, the first scan driving circuit 11 may be arranged on one side of the display area DA and the emission control driving circuit 13 may be arranged on the other side.

The pad 14 may be arranged in the second peripheral area PA2 of the substrate 100. The pad 14 may not be covered by an insulating layer and may be exposed, and thus, may be electrically connected to the display circuit board 30. A pad 34 of the display circuit board 30 may be electrically connected to the pad 14 of the display panel 10.

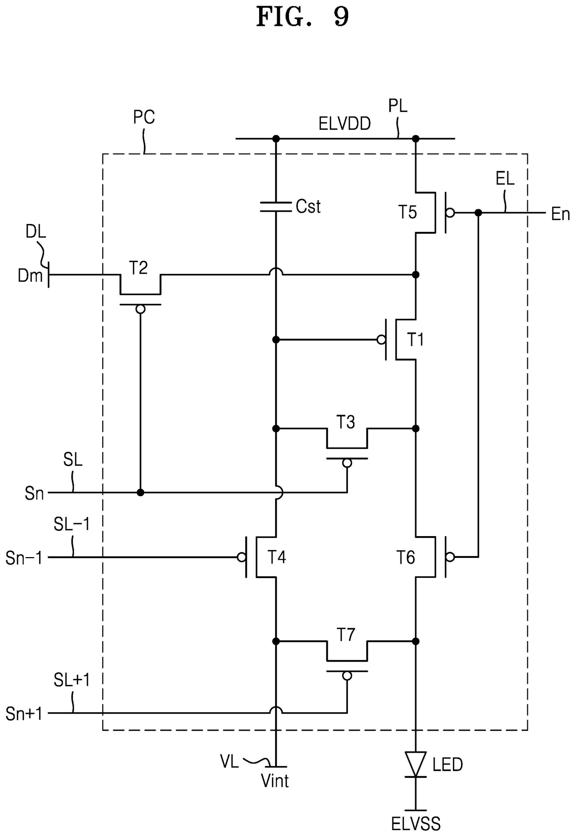

The display circuit board 30 transmits a signal or power of a controller to the display panel 10. A control signal generated by the controller may be transmitted to the gate driving circuit via the display circuit board 30. Also, the controller may provide a first power supply voltage ELVDD (see FIG. 9) and a second power supply voltage ELVSS(see FIG. 9) to the first power supply wiring 15 and the second power supply wiring 16, respectively. The first power supply voltage ELVDD (hereinafter, referred to as a driving voltage) may be provided to each sub-pixel circuit PC via a driving voltage line PL connected to the first power supply wiring 15, and the second power supply voltage ELVSS (hereinafter, referred to as a common voltage) may be provided to a common electrode of the light-emitting diode LED connected to the second power supply wiring 16. The first power supply wiring 15 may extend in the first direction (the x-axis direction). The second power supply wiring 16 may have a loop shape with one side open, and may be partially around (e.g., partially surround) the display area DA.

A data signal of the data driver 20 may be transmitted to the sub-pixel circuit PC via a data line DL electrically connected to the input line IL via an input line IL.

FIG. 9 is a circuit diagram schematically illustrating a sub-pixel circuit PC of a sub-pixel arranged in a display area shown in FIG. 8.

Referring to FIG. 9, the light-emitting diode LED may be electrically connected to the sub-pixel circuit PC.

The sub-pixel circuit PC may include a first thin-film transistor T1, a second thin-film transistor T2, a third thin-film transistor T3, a fourth thin-film transistor T4, a fifth thin-film transistor T5, a sixth thin-film transistor T6, a seventh thin-film transistor T7, and a storage capacitor Cst.

The second thin-film transistor T2 that is a switching thin-film transistor may be connected to the scan line SL and the data line DL, and may transmit a data voltage (or a data signal Dm) input from the data line DL to the first thin-film transistor T1, based on a switching voltage (or a scan signal Sn) input from the scan line SL, wherein m and n are natural numbers excluding 0. The storage capacitor Cst may be connected to a gate electrode of the first thin-film transistor T1 and the driving voltage line PL, and may store a voltage corresponding to a difference between a voltage at the gate electrode of the first thin-film transistor T1 and the first power supply voltage ELVDD supplied to the driving voltage line PL.

The first thin-film transistor T1 that is a driving thin-film transistor may be connected to the driving voltage line PL and the storage capacitor Cst, and may control driving current flowing from the driving voltage line PL to the light-emitting diode LED, in response to a value of the voltage stored in the storage capacitor Cst. The light-emitting diode LED may emit light having a suitable luminance (e.g., a preset luminance) caused by the driving current. A second electrode (e.g., a cathode) of the light-emitting diode LED may receive the second power supply voltage ELVSS.

The third thin-film transistor T3 is a compensation thin-film transistor, and a gate electrode of the third thin-film transistor T3 may be connected to the scan line SL. A source electrode (or a drain electrode) of the third thin-film transistor T3 may be connected to a drain electrode (or a source electrode) of the first thin-film transistor T1, and may be connected to a first electrode of the light-emitting diode LED via the sixth thin-film transistor T6. The drain electrode (or the source electrode) of the third thin-film transistor T3 may be connected to one electrode of the storage capacitor Cst, a source electrode (or a drain electrode) of the fourth thin-film transistor T4, and a gate electrode of the first thin-film transistor T1. When the third thin-film transistor T3 is turned on, in response to the scan signal Sn received via the scan line SL, the third thin-film transistor T3 diode-connects the first thin-film transistor T1 by connecting the gate electrode and the drain electrode of the first thin-film transistor T1.

A gate electrode of the fourth thin-film transistor T4 that is an initialization thin-film transistor may be connected to a previous scan line SL-1. The drain electrode (or the source electrode) of the fourth thin-film transistor T4 may be connected to an initialization voltage line VL. The source electrode (or the drain electrode) of the fourth thin-film transistor T4 may be connected to one electrode of the storage capacitor Cst, the drain electrode (or the source electrode) of the third thin-film transistor T3, and the gate electrode of the first thin-film transistor T1. The fourth thin-film transistor T4 may be turned on, in response to a previous scan signal Sn-1 received through the previous scan line SL-1, and may perform an initialization operation of initializing a voltage of the gate electrode of the first thin-film transistor T1 by supplying an initialization voltage Vint to the gate electrode of the first thin-film transistor T1.

A gate electrode of the fifth thin-film transistor T5 that is an operation control thin-film transistor may be connected to an emission control line EL. A source electrode (or a drain electrode) of the fifth thin-film transistor T5 may be connected to the driving voltage line PL. The drain electrode (or the source electrode) of the fifth thin-film transistor T5 is connected to the source electrode (or the drain electrode) of the first thin-film transistor T1 and a drain electrode (or a source electrode) of the second thin-film transistor T2.

A gate electrode of the sixth thin-film transistor T6 that is an emission control thin-film transistor may be connected to the emission control line EL. A source electrode (or a drain electrode) of the sixth thin-film transistor T6 may be connected to the drain electrode (or the source electrode) of the first thin-film transistor T1 and the source electrode (or the drain electrode) of the third thin-film transistor T3. The drain electrode (or the source electrode) of the sixth thin-film transistor T6 may be electrically connected to the first electrode of the light-emitting diode LED. The fifth thin-film transistor T5 and the sixth thin-film transistor T6 may be concurrently (e.g., simultaneously) turned on, in response to an emission control signal En received via the emission control line EL, and thus, the first power supply voltage ELVDD is supplied to the light-emitting diode LED and driving current flows through the light-emitting diode LED.

The seventh thin-film transistor T7 may be an initialization thin-film transistor for initializing the first electrode of the light-emitting diode LED. A gate electrode of the seventh thin-film transistor T7 may be connected to a next scan line SL+1. A source electrode (or a drain electrode) of the seventh thin-film transistor T7 may be connected to the first electrode of the light-emitting diode LED. The drain electrode (or the source electrode) of the seventh thin-film transistor T7 may be connected to the initialization voltage line VL. The seventh thin-film transistor T7 may be turned on, in response to a next scan signal Sn+1 received via the next scan line SL+1, and may initialize the first electrode of the light-emitting diode LED.

Referring to FIG. 9, it is illustrated that the fourth thin-film transistor T4 and the seventh thin-film transistor T7 are respectively connected to the previous scan line SL-1 and the next scan line SL+1, but, in another embodiment, both the fourth thin-film transistor T4 and the seventh thin-film transistor T7 may be connected to the previous scan line SL-1 and may be driven according to the previous scan signal Sn-1.

The other electrode of the storage capacitor Cst may be connected to the driving voltage line PL. One electrode of the storage capacitor Cst may be connected to the gate electrode of the first thin-film transistor T1, the drain electrode (or the source electrode) of the third thin-film transistor T3, and the source electrode (or the drain electrode) of the fourth thin-film transistor T4.

The second electrode (e.g., cathode) of the light-emitting diode LED receives the second power supply voltage ELVSS. The light-emitting diode LED emits light by receiving driving current from the first thin-film transistor T1.

The light-emitting diode LED may be an organic light-emitting diode (OLED) including an organic material as a light-emitting material. In another embodiment, the light-emitting diode may be an inorganic light-emitting diode including an inorganic material. The inorganic light-emitting diode may include a PN junction diode including inorganic semiconductor-based materials. When a voltage is applied to a PN junction diode in a forward direction, holes and electrons may be injected, and energy generated by recombination of the holes and electrons may be converted into light energy to emit light of a suitable color (e.g., preset color). The inorganic light-emitting diode may have a width of several to hundreds of micrometers, or several to hundreds of nanometers. In one or more embodiments, the light-emitting diode LED may include a quantum-dot light-emitting diode. As described above, an emission layer of the light-emitting diode LED may include an organic material, may include an inorganic material, may include quantum dots, may include an organic material and quantum dots, or may include an inorganic material and quantum dots. For convenience of descriptions, a case in which the light-emitting diode LED includes an organic light-emitting diode (OLED) will be described.

Referring to FIG. 9, it is illustrated that the sub-pixel circuit PC includes seven transistors and one capacitor, but, in another embodiment, the sub-pixel circuit PC may include two or more transistors and may include two or more capacitors. Also, a circuit design of the sub-pixel circuit PC is not limited to that illustrated in FIG. 9 and may be modified in various manners.

The first to seventh thin-film transistors T1, T2, T3, T4, T5, T6, and T7 may be various types of transistors. In one or more embodiments, as shown in FIG. 9, all of the first to seventh thin-film transistors T1, T2, T3, T4, T5, T6, and T7 may be p-channel metal-oxide-semiconductor field-effect transistor (MOSFETs) (PMOSs). In another embodiment, at least one of the first to seventh thin-film transistors T1, T2, T3, T4, T5, T6, or T7 may be a PMOS, and others may be n-channel MOSFETs (NMOSs). In another embodiment, all of the first to seventh thin-film transistors T1, T2, T3, T4, T5, T6, and T7 may be NMOSs. Positions of sources and drains are interchangeable according to a type (a p-type or an n-type) of a transistor.

All of the first to seventh thin-film transistors T1, T2, T3, T4, T5, T6, and T7 of FIG. 9 may be transistors including a low-temperature silicon semiconductor. Here, the first to seventh thin-film transistors T1, T2, T3, T4, T5, T6, and T7 are not limited thereto, and at least one of the first to seventh thin-film transistors T1, T2, T3, T4, T5, T6, or T7 may be a transistor having a low-temperature polycrystalline silicon (LTPS) semiconductor layer, and others may be transistors having an oxide semiconductor layer. Alternatively, all of the first to seventh thin-film transistors T1, T2, T3, T4, T5, T6, and T7 may be transistors having an oxide semiconductor layer.

FIG. 10A is a cross-sectional view schematically illustrating a portion of the display apparatus shown in FIG. 6.

Referring to FIG. 10A, the display apparatus may include the display panel 10 including the substrate 100, a display layer 200, an encapsulation layer 400, a touch sensor layer 500, and an anti-reflection layer 600, an adhesive layer OCA, and the cover window 70.

The substrate 100 may include glass and/or polymer resin. For example, the polymer resin may include polyethersulfone, polyacrylate, polyetherimide, polyethylene naphthalate, polyethylene terephthalate, polyphenylene sulfide, polyarylate, polyimide, polycarbonate, and/or cellulose acetate propionate. The substrate 100 including polymer resin may have a flexible, rollable, and/or bendable characteristic. The substrate 100 may form a multi-layer structure including a layer including polymer resin and an inorganic layer.

The display layer 200 may include a thin-film transistor electrically connected to a light-emitting diode, e.g., an organic light-emitting diode, and insulating layers arranged therebetween.

In one or more embodiments, the display panel 10 may further include a low-reflection layer on the display layer 200, and the encapsulation layer 400 may be arranged on the low-reflection layer. For example, the display layer 200 and/or the low-reflection layer may be encapsulated with the encapsulation layer 400. In one or more embodiments, the low-reflection layer may be omitted. In this case, the encapsulation layer 400 may be directly arranged on the display layer 200. The encapsulation layer 400 may include at least one inorganic encapsulation layer and at least one organic encapsulation layer.

In one or more embodiments, an encapsulation substrate including a glass material may be arranged, instead of the encapsulation layer 400. The encapsulation substrate may be arranged on the display layer 200, and the display layer 200 may be arranged between the substrate 100 and the encapsulation substrate. A gap may occur between the encapsulation substrate and the display layer 200, and may be filled with a filling material.

The touch sensor layer 500 may be arranged on the encapsulation layer 400. The touch sensor layer 500 may detect an external input, e.g., a touch of an object such as a finger or a stylus pen, and thus, may allow the display apparatus to obtain coordinate information corresponding to a location of the touch. The touch sensor layer 500 may include a touch electrode and trace lines connected to the touch electrode. The touch sensor layer 500 may detect the external input by a mutual-cap (e.g., mutual capacitance) scheme or a self-cap (e.g., self-capacitance) scheme.

The touch sensor layer 500 may be directly arranged on the encapsulation layer 400. Alternatively, the touch sensor layer 500 may be separately formed and then may be adhered to the encapsulation layer 400 via an adhesive layer such as an optically clear adhesive.

The anti-reflection layer 600 may be arranged on the touch sensor layer 500. The anti-reflection layer 600 may decrease a reflectivity of external light incident from the outside to the display apparatus via the cover window 70.

The anti-reflection layer 600 may include a light-blocking layer and/or color filters. The color filters may be arrayed by considering colors of light beams respectively emitted from light-emitting diodes of the display layer 200.

The cover window 70 may be arranged on the anti-reflection layer 600. The cover window 70 may protect covered layers. The cover window 70 may be separately formed and then may be adhered to the anti-reflection layer 600 via an adhesive layer OCA arranged between the anti-reflection layer 600 and the cover window 70. The adhesive layer OCA may be, for example, an optically clear adhesive. Alternatively, the cover window 70 may be directly formed on the anti-reflection layer 600.

In one or more embodiments, the touch sensor layer 500 may be arranged on the anti-reflection layer 600. In this case, the anti-reflection layer 600 may be arranged on the encapsulation layer 400, and the touch sensor layer 500, the adhesive layer OCA, and the cover window 70 may be sequentially arranged over the anti-reflection layer 600. Hereinafter, for convenience of descriptions, a case in which the anti-reflection layer 600 is arranged on the touch sensor layer 500 will be mainly described.

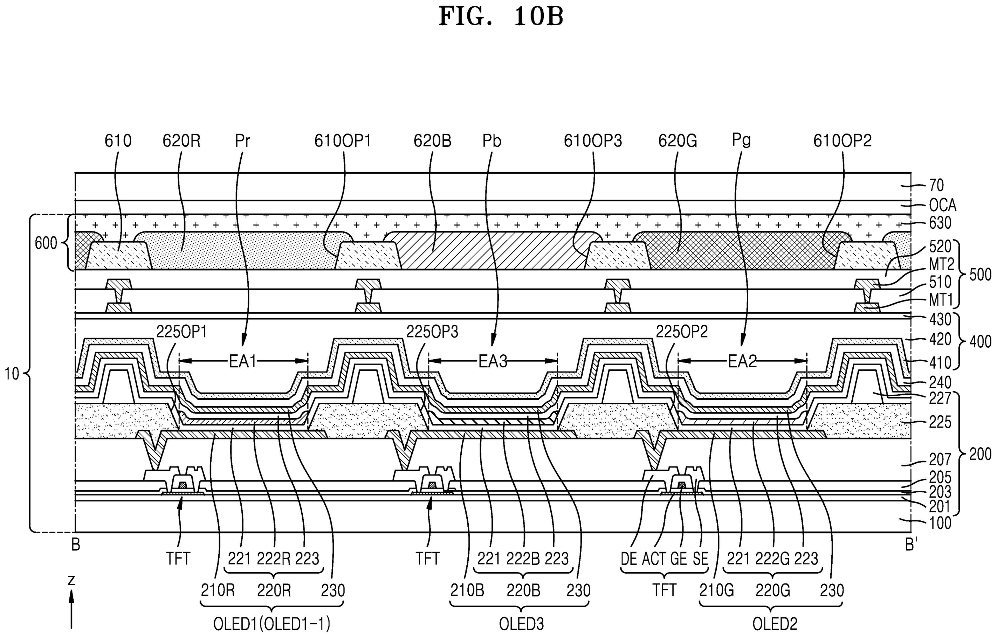

FIG. 10B is a cross-sectional view schematically illustrating the display panel 10, the adhesive layer OCA, and the cover window 70, taken along the line B-B' of FIG. 8.

Referring to FIG. 10B, the display apparatus may include the display panel 10 including the substrate 100, the display layer 200, the encapsulation layer 400, the touch sensor layer 500, and the anti-reflection layer 600, the adhesive layer OCA, and cover window 70.

The display apparatus may include a plurality of sub-pixels arranged in the display area DA (see FIG. 8). Each of the plurality of sub-pixels may emit red light, green light, or blue light. The plurality of sub-pixels may include sub-pixels such as a first sub-pixel, a second sub-pixel, and a third sub-pixel, which output light of different colors. Each of the first sub-pixel, the second sub-pixel, and the third sub-pixel may be provided in plural. In one or more embodiments, the first sub-pixel may be a red sub-pixel Pr capable of emitting red light, the second sub-pixel may be a green sub-pixel Pg capable of emitting green light, and the third sub-pixel may be a blue sub-pixel Pb capable of emitting blue light.

The display layer 200 may be arranged on the substrate 100. The display layer 200 may include a sub-pixel circuit layer and a light-emitting diode layer. The sub-pixel circuit layer may include a thin-film transistor TFT, and may include a buffer layer 201, a gate insulating layer 203, an intermediate insulating layer 205, and a planarization layer 207.

The buffer layer 201 may be arranged on the substrate 100, and thus, may prevent penetration of foreign substances, moisture, and/or outside air from below the substrate 100 and may provide a flat surface on the substrate 100. The buffer layer 201 may include an inorganic material, such as an oxide and/or a nitride, an organic material, or an organic/inorganic composite material and may have a single-layer or multilayer structure including an inorganic material and/or an organic material. A barrier layer that prevents infiltration of outside air may be further included between the substrate 100 and the buffer layer 201. For example, the buffer layer 201 may include silicon oxide and/or silicon nitride.

The thin-film transistor TFT may be arranged on the buffer layer 201. The thin-film transistor TFT may include a semiconductor layer ACT, a gate electrode GE, a source electrode SE, and a drain electrode DE. The thin-film transistor TFT may be connected to an organic light-emitting diode (OLED), and may drive the organic light-emitting diode (OLED).

The semiconductor layer ACT may be arranged on the buffer layer 201. The semiconductor layer ACT may include polysilicon and/or amorphous silicon. Alternatively, the semiconductor layer ACT may include an oxide of indium (In), gallium (Ga), stannum (Sn), zirconium (Zr), vanadium (V), hafnium (Hf), cadmium (Cd), germanium (Ge), chromium (Cr), titanium (Ti), and/or zinc (Zn). The semiconductor layer ACT may include a channel region, and a source region and a drain region doped with impurities.

The gate electrode GE, the source electrode SE, and the drain electrode DE may include various conductive materials. In one or more embodiments, the gate electrode GE may include molybdenum (Mo), aluminum (Al), copper (Cu), and/or titanium (Ti). For example, the gate electrode GE may include a single layer of molybdenum (Mo) or may include a triple-layer structure including a layer of molybdenum (Mo), a layer of aluminum (Al), and a layer of molybdenum (Mo). In one or more embodiments, the source electrode SE and the drain electrode DE may include at least one material selected from copper (Cu), titanium (Ti), or aluminum (Al). For example, the source electrode SE and the drain electrode DE may each include a triple-layer structure including a layer of titanium (Ti), a layer of aluminum (Al), and a layer of titanium (Ti).

The gate insulating layer 203 may be arranged between the semiconductor layer ACT and the gate electrode GE so as to allow the semiconductor layer ACT to be insulated from the gate electrode GE. The intermediate insulating layer 205 may be arranged on the gate electrode GE, and the source electrode SE and the drain electrode DE may be arranged on the intermediate insulating layer 205.

Each of the gate insulating layer 203 and the intermediate insulating layer 205 may include an inorganic material such as silicon oxide, silicon nitride, and/or silicon oxynitride. The gate insulating layer 203 and the intermediate insulating layer 205 may be formed via chemical vapor deposition (CVD) and/or atomic layer deposition (ALD).

The planarization layer 207 may be arranged on the thin-film transistor TFT. In order to provide a flat top surface, the planarization layer 207 may be formed and then mechanical polishing may be performed on a top surface of the planarization layer 207. The planarization layer 207 may include general-purpose polymer (e.g., photosensitive polyimide, polyimide, polycarbonate (PC), benzocyclobutene (BCB), HMDSO, polymethylmethacrylate (PMMA), and/or polystyrene (PS)), polymer derivatives having a phenolic group, acrylic polymer, imide-based polymer, aryl etherbased polymer, amide-based polymer, fluorine-based polymer, p-xylene-based polymer, and/or vinyl alcohol-based polymer. Referring to FIG. 10B, the planarization layer 207 is shown as a single layer, but, in one or more embodiments, the planarization layer 207 may have a plurality of layers. First, second, and third sub-pixel electrodes 210R, 210G, and 210B of each of first, second, and third organic light-emitting diodes OLED1, OLED2, and OLED3, which are a first display element, a second display element, and a third display element may be electrically connected to the thin-film transistor TFT through a contact hole of the planarization layer 207. In this regard, the first organic light-emitting diode OLED1 or the second organic light-emitting diode OLED2 may include a first distinguished display element or a second distinguished display element, which is to be described below.

The light-emitting diode layer may be arranged on the sub-pixel circuit layer. In one or more embodiments, the light-emitting diode layer may include the first, second, and third organic light-emitting diodes OLED1, OLED2, and OLED3, a bank layer 225, and a spacer 227.

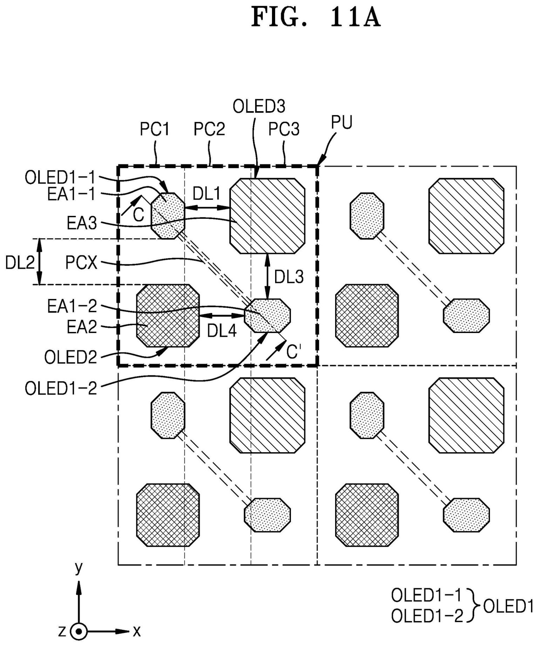

The first, second, and third organic light-emitting diodes OLED1, OLED2, and OLED3 may be arranged on the sub-pixel circuit layer. The first organic light-emitting diode OLED1 may include a first sub-pixel electrode 210R, a first intermediate layer 220R including a first common layer 221, a first emission layer 222R, and a second common layer 223, and an opposite electrode 230, the second organic light-emitting diode OLED2 may include a stack structure of a second sub-pixel electrode 210G, a second intermediate layer 220G including the first common layer 221, a second emission layer 222G, and the second common layer 223, and the opposite electrode 230, and the third organic light-emitting diode OLED3 may include a third sub-pixel electrode 210B, a third intermediate layer 220B including the first common layer 221, a third emission layer 222B, and the second common layer 223, and the opposite electrode 230. In the above case, the first organic light-emitting diode OLED1 may be a first distinguished organic light-emitting diode OLED1-1 or a second distinguished organic light-emitting diode OLED1-2, which is shown in FIG. 11A, 11B, 14, 15, 16, or 17 to be described below.

The first, second, and third sub-pixel electrodes 210R, 210G, and 210B may be arranged on the planarization layer 207. The first, second, and third sub-pixel electrodes 210R, 210G, and 210B may be arranged by being spaced (e.g., spaced apart) from each other.

The first, second, and third sub-pixel electrodes 210R, 210G, and 210B may each be a reflection electrode. The first, second, and third sub-pixel electrodes 210R, 210G, and 210B may each include a reflection layer including silver (Ag), magnesium (Mg), aluminum (Al), platinum (Pt), palladium (Pd), gold (Au), nickel (Ni), neodymium (Nd), iridium (Ir), chromium (Cr), or any compound thereof, and a transparent or translucent conductive layer formed on the reflection layer. The transparent or translucent conductive layer may include at least one material selected from indium tin oxide (ITO), indium zinc oxide (IZO), zinc oxide (ZnO), indium oxide (In₂O₃), indium gallium oxide (IGO), or aluminum zinc oxide (AZO).

The bank layer 225 may be arranged on the first, second, and third sub-pixel electrodes 210R, 210G, and 210B. The bank layer 225 may have first, second, and third bottom openings 225OP1, 225OP2, and 2225OP3 which overlap top portions of the first, second, and third sub-pixel electrodes 210R, 210G, and 210B and respectively expose center portions of the first, second, and third sub-pixel electrodes 210R, 210G, and 210B. The bank layer 225 may cover edges of the first, second, and third sub-pixel electrodes 210R, 210G, and 210B, and may increase a gap between the edges of the first, second, and third sub-pixel electrodes 210R, 210G, and 210B and the opposite electrode 230, thereby preventing an electric arc from occurring in the edges of the first, second, and third sub-pixel electrodes 210R, 210G, and 210B.

The first, second, and third bottom openings 225OP1, 225OP2, and 2225OP3 of the bank layer 225 may define first, second, and third emission areas EA1, EA2, and EA3 of the first, second, and third organic light-emitting diodes OLED1, OLED2, and OLED3 included in each sub-pixel. As shown in FIG. 10B, the bank layer 225 may include the first bottom opening 225OP1 that defines the first emission area EA1 of the first organic light-emitting diode OLED1 of the first sub-pixel. Also, the bank layer 225 may include the second bottom opening 225OP2 that defines the second emission area EA2 of the second organic light-emitting diode OLED2 of the second sub-pixel, and the third bottom opening 225OP3 that defines the third emission area EA3 of the third organic light-emitting diode OLED3 of the third sub-pixel.

The bank layer 225 may include an organic insulating material. Alternatively, the bank layer 225 may include an inorganic insulating material such as silicon nitride and/or silicon oxide. In one or more embodiments, the bank layer 225 may include an organic insulating material and/or an inorganic insulating material.

In one or more embodiments, the bank layer 225 may include a light blocking material. For example, the light blocking material of the bank layer 225 may be black color. The light blocking material may include a resin or paste including carbon black, carbon nanotubes, a black dye, metal particles such as nickel, aluminum, molybdenum, and/or any alloy thereof, metal oxide particles, and/or metal nitride particles, etc. When the bank layer 225 includes the light blocking material, external light reflection due to metal structures arranged under the bank layer 225 may be decreased.

The spacer 227 may be arranged on the bank layer 225. The spacer 227 may include an organic insulating material such as polyimide. Alternatively, the spacer 227 may include an inorganic insulating material such as silicon nitride and/or silicon oxide, or may include an organic insulating material and an inorganic insulating material. In one or more embodiments, the spacer 227 may include a material different from the bank layer 225 including the light blocking material, and may be formed in a separate process.

In another embodiment, the spacer 227 and the bank layer 225 may include the same material. In this case, the bank layer 225 and the spacer 227 may be formed together in a mask process using a half tone mask, and/or the like.

An intermediate layer may be arranged on the first, second, and third sub-pixel electrodes 210R, 210G, and 210B and the bank layer 225. In one or more embodiments, the intermediate layer may also be arranged on the spacer 227. As described above, the intermediate layer may include the first common layer 221, an emission layer (e.g., the first, second, third emission layers 222R, 222G, 222B), and the second common layer 223.

The first, second, and third emission layers 222R, 222G, and 222B may be arranged in the first, second, and third bottom openings 225OP1, 225OP2, and 225OP3 of the bank layer 225. The first, second, and third emission layers 222R, 222G, and 222B may each include an organic material including a fluorescent and/or phosphorescent material capable of emitting red light, green light, or blue light. The aforementioned organic material may include a small molecule organic material or a polymer organic material.

The first common layer 221 and the second common layer 223 may be respectively arranged under and on the emission layer (e.g., the first, second, third emission layers 222R, 222G, 222B). The first common layer 221 may include a hole transport layer (HTL), or may include the HTL and a hole injection layer (HIL). The second common layer 223 may include an electron transport layer (ETL), or may include the ETL and an electron injection layer (EIL). In one or more embodiments, the second common layer 223 may not be provided.

The emission layer is arranged at each sub-pixel so as to correspond to the first, second, and third bottom openings 225OP1, 225OP2, and 225OP3 of the bank layer 225, whereas each of the first common layer 221 and the second common layer 223 may be integrally formed to entirely cover the substrate 100. In other words, each of the first common layer 221 and the second common layer 223 may be integrally formed to entirely cover the display area DA of the substrate 100.

The opposite electrode 230 may be a cathode that is an electron injection electrode. The opposite electrode 230 may include a conductive material having a low work function. For example, the opposite electrode 230 may include a (semi)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), and/or any alloy thereof. Alternatively, the opposite electrode 230 may further include a layer including ITO, IZO, ZnO, and/or In₂O₃ on the (semi)transparent layer including the material described above.

In one or more embodiments, a capping layer 240 may be further arranged on the display layer 200. The capping layer 240 may be arranged on the first, second, and third organic light-emitting diodes OLED1, OLED2, and OLED3. In one or more embodiments, the capping layer 240 may increase emission efficiency of the first, second, and third organic light-emitting diodes OLED1, OLED2, and OLED3, due to a constructive interference principle.

The capping layer 240 may be an organic capping layer including an organic material, an inorganic capping layer including an inorganic material, or a composite capping layer including an organic material and an inorganic material. For example, the capping layer 240 may include a carbocyclic compound, a heterocyclic compound, an amine group-containing compound, porphyrin derivatives, phthalocyanine derivatives, naphthalocyanine derivatives, an alkali metal complex, an alkali earth metal complex, or any combination thereof. The carbocyclic compound, the heterocyclic compound, and/or the amine group-containing compound may be optionally substituted with substituents including O, N, S, Se, Si, F, Cl, Br, I, or any combination thereof.

The encapsulation layer 400 may be arranged on the capping layer 240. The encapsulation layer 400 may include at least one inorganic encapsulation layer and at least one organic encapsulation layer. For example, as shown in FIG. 10B, the encapsulation layer 400 may include a first inorganic encapsulation layer 410, an organic encapsulation layer 420, and a second inorganic encapsulation layer 430, which are sequentially stacked.

The first inorganic encapsulation layer 410 and the second inorganic encapsulation layer 430 may each include an inorganic insulating material such as silicon oxide, silicon nitride, aluminum oxide, titanium oxide, tantalum oxide, hafnium oxide, zinc oxide, etc. The first inorganic encapsulation layer 410 and the second inorganic encapsulation layer 430 may be a single layer or multiple layers including the aforementioned inorganic insulating material.

The organic encapsulation layer 420 may decrease an internal stress of the first inorganic encapsulation layer 410 and/or the second inorganic encapsulation layer 430. The organic encapsulation layer 420 may include a polymer-based material. For example, the organic encapsulation layer 420 may include polyethyleneterephthalate, polyethylenenaphtalate, polycarbonate, polyimide, polyethylenesulfonate, polyoxymethylene, polyarylate, hexamethyldisiloxane, an acrylate-based resin (e.g., polymethylmethacrylate, polyacrylic acid, etc.), or any combination thereof.

The encapsulation layer 400 may have a multilayer structure of the first inorganic encapsulation layer 410, the organic encapsulation layer 420, and the second inorganic encapsulation layer 430. In this case, even when a crack occurs in the encapsulation layer 400, the crack may not be propagated between the first inorganic encapsulation layer 410 and the organic encapsulation layer 420 or between the organic encapsulation layer 420 and the second inorganic encapsulation layer 430. The encapsulation layer 400 may prevent or minimize penetration of external moisture and/or oxygen into the display area DA.

The touch sensor layer 500 may be arranged on the encapsulation layer 400. The touch sensor layer 500 may include a first touch electrode MT1, a first touch insulating layer 510, a second touch electrode MT2, and a second touch insulating layer 520. The first touch electrode MT1 may be directly arranged on the encapsulation layer 400. For example, the first touch electrode MT1 may be directly arranged on the second inorganic encapsulation layer 430 of the encapsulation layer 400. However, the present invention is not limited thereto.

In one or more embodiments, the touch sensor layer 500 may include an insulating layer arranged between the first touch electrode MT1 and the encapsulation layer 400. Here, the insulating layer may be arranged on the second inorganic encapsulation layer 430 of the encapsulation layer 400, and thus, may flatten a surface on which the first touch electrode MT1, etc. is to be arranged. The insulating layer may include an inorganic insulating material such as silicon oxide, silicon nitride, silicon oxynitride, etc. In one or more embodiments, the insulating layer may include an organic insulating material.

The first touch insulating layer 510 may be arranged on the first touch electrode MT1. The first touch insulating layer 510 may include an inorganic material and/or an organic material. When the first touch insulating layer 510 includes the inorganic material, the first touch insulating layer 510 may include at least one material selected from silicon nitride, aluminum nitride, zirconium nitride, titanium nitride, hafnium nitride, tantalum nitride, silicon oxide, aluminum oxide, titanium oxide, tin oxide, cerium oxide, or silicon oxynitride. When the first touch insulating layer 510 includes the organic material, the first touch insulating layer 510 may include at least one material selected from an acrylic-based resin, a methacrylic-based resin, polyisoprene, a vinyl-based resin, an epoxy-based resin, a urethane-based resin, a cellulose-based resin, or a perylene-based resin.

The second touch electrode MT2 may be arranged on the first touch insulating layer 510. The second touch electrode MT2 may serve as a sensor for detecting a user's touch input. The first touch electrode MT1 may serve as a connector for connecting the patterned second touch electrode MT2 in one direction. In one or more embodiments, both the first touch electrode MT1 and the second touch electrode MT2 may serve as sensors. In this case, the first touch electrode MT1 and the second touch electrode MT2 may be electrically connected to each other through a contact hole. When both the first touch electrode MT1 and the second touch electrode MT2 serve as sensors, resistance of a touch electrode may decrease so that the user's touch input may be detected rapidly.

In one or more embodiments, the first touch electrode MT1 and the second touch electrode MT2 may have a structure, e.g., a mesh structure, through which light emitted from an organic light emitting diode may be transmitted. In this regard, the first touch electrode MT1 and the second touch electrode MT2 may be arranged not to overlap each emission area of an organic light emitting diode.

The first touch electrode MT1 and the second touch electrode MT2 may each include a metal layer or a transparent conductive layer. The metal layer may include molybdenum (Mo), silver (Ag), titanium (Ti), copper (Cu), aluminum (Al), and/or an alloy thereof. The transparent conductive layer may include transparent conductive oxide such as indium tin oxide (ITO), indium zinc oxide (IZO), zinc oxide (ZnO), indium tin zinc oxide (ITZO), etc., conductive polymers such as poly(3,4-ethylenedioxythiophene) (PEDOT), metal nanowire, carbon nanotube, graphene, and/or the like.

The second touch insulating layer 520 may be arranged on the second touch electrode MT2. The second touch insulating layer 520 may include an inorganic material and/or an organic material. When the second touch insulating layer 520 includes the inorganic material, the second touch insulating layer 520 may include at least one material selected from silicon nitride, aluminum nitride, zirconium nitride, titanium nitride, hafnium nitride, tantalum nitride, silicon oxide, aluminum oxide, titanium oxide, tin oxide, cerium oxide, or silicon oxynitride. When the second touch insulating layer 520 includes the organic material, the second touch insulating layer 520 may include at least one material selected from an acrylic-based resin, a methacrylic-based resin, polyisoprene, a vinyl-based resin, an epoxy-based resin, a urethane-based resin, a cellulose-based resin, or a perylene-based resin.

In one or more embodiments, the touch sensor layer 500 may include the first touch electrode MT1, the first touch insulating layer 510, and the second touch electrode MT2, but may not include the second touch insulating layer 520. In this case, the anti-reflection layer 600 may be provided to cover the second touch electrode MT2.

The anti-reflection layer 600 may be arranged on the touch sensor layer 500.

Referring to FIG. 10B, the anti-reflection layer 600 may include a light-blocking layer 610 and a plurality of color filters. In one or more embodiments, the anti-reflection layer 600 may include first, second, and third color filters 620R, 620G, and 620B, which have different colors and respectively correspond to first, second, and third organic light-emitting diodes OLED1, OLED2, and OLED3. Each of the first, second, and third color filters 620R, 620G, and 620B may be provided in plural.

The light-blocking layer 610 may include first, second, and third top openings 610OP1, 610OP2, and 610OP3, which respectively correspond to first, second, and third sub-pixels. The light-blocking layer 610 may include the first top opening 610OP1 corresponding to the first emission area EA1, the second top opening 610OP2 corresponding to the second emission area EA2, and the third top opening 610OP3 corresponding to the third emission area EA3. Light beams emitted from the first, second, and third organic light-emitting diodes OLED1, OLED2, and OLED3 may be output through the first, second, and third top openings 610OP1, 610OP2, and 610OP3 of the light-blocking layer 610.

The first top opening 610OP1 of the light-blocking layer 610 may overlap the first bottom opening 225OP1 of the bank layer 225, the second top opening 610OP2 may overlap the second bottom opening 225OP2, and the third top opening 610OP3 may overlap the third bottom opening 225OP3.

In the present specification, a width (or size) of each pixel may indicate a width (or size) of an emission area of an organic light-emitting diode (OLED) constituting each sub-pixel, and a width (or size) of the emission area may be defined by a width (or size) of a bottom opening included in the bank layer 225.

In one or more embodiments, a width (or size) of each of the first, second, and third top openings 610OP1, 610OP2, and 610OP3 of the light-blocking layer 610 may be arranged to be greater than (e.g., may be greater than) a width (or size) of a corresponding sub-pixel from among the first, second, and third sub-pixels. That is, a width (or size) of each of the first, second, and third top openings 610OP1, 610OP2, and 610OP3 of the light-blocking layer 610 may be greater than a width (or size) of each of the first, second, and third bottom openings 225OP1, 225OP2, and 225OP3 of the bank layer 225.

In one or more embodiments, a width (or size) of each of the first, second, and third top openings 610OP1, 610OP2, and 610OP3 of the light-blocking layer 610 may be substantially equal to a width (or size) of a corresponding sub-pixel from among the first, second, and third sub-pixels. That is, a width (or size) of each of the first, second, and third top openings 610OP1, 610OP2, and 610OP3 of the light-blocking layer 610 may be substantially equal to a width (or size) of each of the first, second, and third bottom openings 225OP1, 225OP2, and 225OP3 of the bank layer 225.

The light-blocking layer 610 may include an organic insulating material. Alternatively, the light-blocking layer 610 may include an inorganic insulating material such as silicon nitride and/or silicon oxide. In one or more embodiments, the light-blocking layer 610 may include an organic insulating material and/or an inorganic insulating material.

In one or more embodiments, the light-blocking layer 610 may include a light blocking material. For example, the light blocking material of the light-blocking layer 610 may be black color. The light blocking material may include a resin or paste including carbon black, carbon nanotubes, a black dye, metal particles such as nickel, aluminum, molybdenum, and/or any alloy thereof, metal oxide particles, and/or metal nitride particles, etc. As the light-blocking layer 610 includes the light blocking material, external light reflection due to metal structures arranged under the light-blocking layer 610 may be decreased.

The first, second, and third color filters 620R, 620G, and 620B may be respectively arranged in the first, second, and third top openings 610OP1, 610OP2, and 610OP3 of the light-blocking layer 610. The first, second, and third color filters 620R, 620G, and 620B may have colors corresponding to light beams emitted from the first, second, and third emission areas EA1, EA2, and EA3. In one or more embodiments, when red light is emitted from the first emission area EA1, the first color filter 620R may be a red color filter, when green light is emitted from the second emission area EA2, the second color filter 620G may be a green color filter, and when blue light is emitted from the third emission area EA3, the third color filter 620B may be a blue color filter.

The anti-reflection layer 600 may further include an overcoat layer 630. The overcoat layer 630 may be arranged on the light-blocking layer 610 and/or the first, second, and third color filters 620R, 620G, and 620B. The overcoat layer 630 may flatten top surfaces of the light-blocking layer 610 and/or the first, second, and third color filters 620R, 620G, and 620B. The overcoat layer 630 is a colorless light-transmitting layer without having a color of a visible spectrum. The overcoat layer 630 may include a colorless light-transmitting organic material such as acrylic-based resin.

The cover window 70 may be arranged over the overcoat layer 630 by having the adhesive layer OCA therebetween.

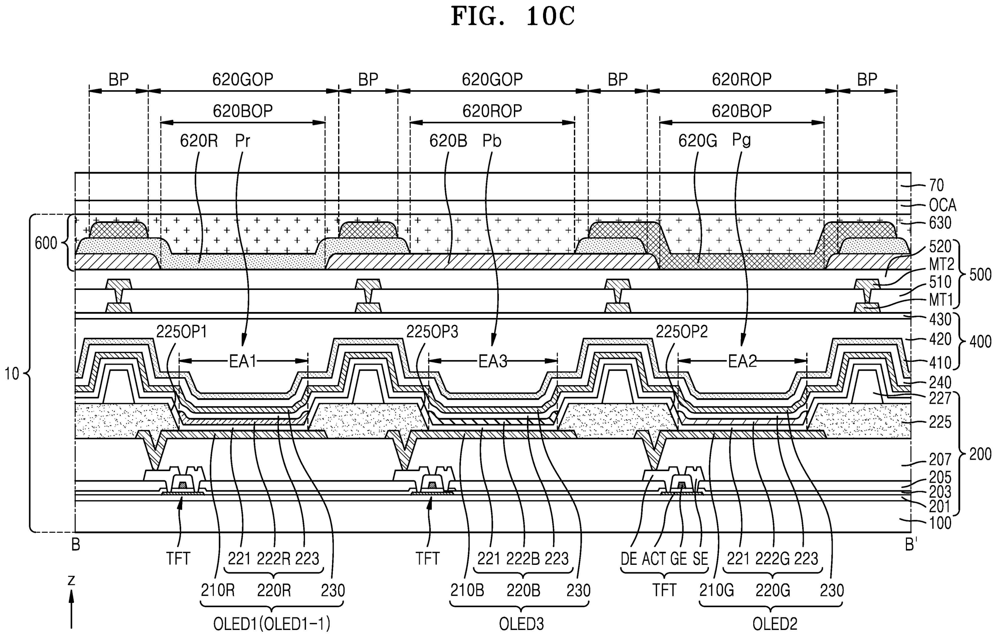

FIG. 10C is a cross-sectional view schematically illustrating the display panel 10, the adhesive layer OCA, and the cover window 70, taken along the line B-B' of FIG. 8. FIG. 10C illustrates a modified embodiment of the anti-reflection layer 600 of FIG. 10B. Hereinafter, differences will now be mainly described.

Referring to FIG. 10C, the anti-reflection layer 600 may not include the light-blocking layer 610 (see FIG. 10B) and may include only a plurality of color filters.

In one or more embodiments, the third color filter 620B, the first color filter 620R, and the second color filter 620G may be sequentially stacked in a direction (+z direction) away from the substrate 100.

The third color filter 620B may transmit most of blue light and may block most of red light and/or green light. The third color filter 620B may have third openings 620BOP corresponding to the second emission area EA2 and the first emission area EA1. The third color filter 620B includes the third openings 620BOP, thereby allowing green light and red light respectively emitted from the second emission area EA2 and the first emission area EA1 not to be blocked. Most of blue light emitted from the third emission area EA3 may pass through the third color filter 620B and may be externally emitted.

The first color filter 620R may transmit most of red light and may block most of blue light and/or green light. The first color filter 620R may be arranged on the third color filter 620B so as to fill an opening from among the third openings 620BOP of the third color filter 620B, the opening corresponding to the first emission area EA1. The first color filter 620R may have first openings 620ROP corresponding to the second emission area EA2 and the third emission area EA3. The first color filter 620R includes the first openings 620ROP, thereby allowing green light and blue light emitted from the second emission area EA2 and the third emission area EA3 not to be blocked. Most of red light emitted from the first emission area EA1 may pass through the first color filter 620R and may be externally emitted.

The second color filter 620G may transmit most of green light and may block most of red light and/or blue light. The second color filter 620G may be arranged on the first color filter 620R so as to fill openings from among the third openings 620BOP of the third color filter 620B and the first openings 620ROP of the first color filter 620R, the openings corresponding to the second emission area EA2. The second color filter 620G may have second openings 620GOP that correspond to the first emission area EA1 and the third emission area EA3. The second color filter 620G includes the second openings 620GOP, thereby allowing red light and blue light emitted from the first emission area EA1 and the third emission area EA3 not to be blocked. Most of green light emitted from the second emission area EA2 may pass through the second color filter 620G and may be externally emitted.

The anti-reflection layer 600 may have light-blocking portions BP in which the third, second, and first color filters 620B, 620R, and 620G are sequentially stacked in gaps between the first, second, and third emission areas EA1, EA2, and EA3 or gaps between the sub-pixel electrodes 210R, 210G, and 210B. The light-blocking portions BP may block light, without including the light-blocking layer 610 (see FIG. 10B) including a black light blocking material. Also, external light reflection of the display apparatus may be decreased.

In one or more embodiments, a width (or size) of the first opening 620ROP of the first color filter 620R which overlaps the second emission area EA2 of the second sub-pixel may be greater than a width (or size) of the third opening 620BOP of the third color filter 620B. A width (or size) of the second opening 620GOP of the second color filter 620G which overlaps the third emission area EA3 of the third sub-pixel may be greater than a width (or size) of the first opening 620ROP of the first color filter 620R. A width (or size) of the second opening 620GOP of the second color filter 620G which overlaps the first emission area EA1 of the first sub-pixel may be greater than a width (or size) of the third opening 620BOP of the third color filter 620B.

Hereinafter, a case in which a display apparatus includes the anti-reflection layer 600 of FIG. 10B will now be described, but the same structure may also be applied to a display apparatus including the anti-reflection layer 600 of FIG. 10C.

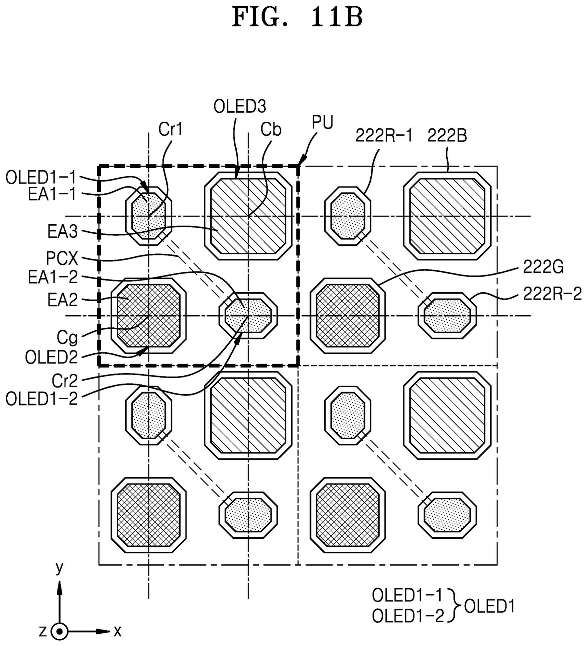

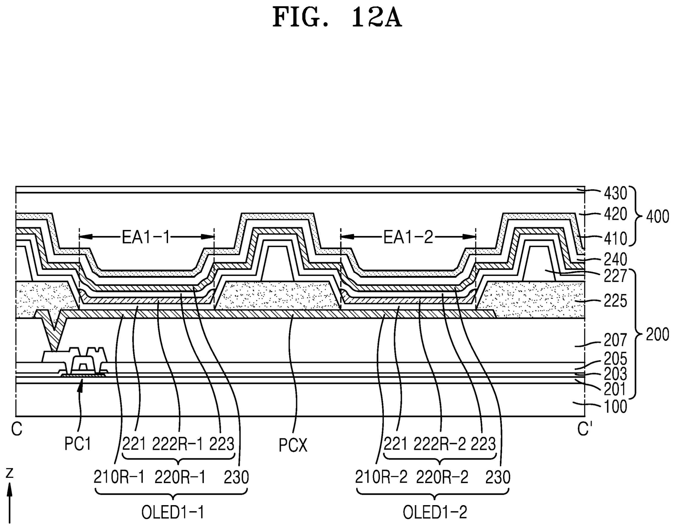

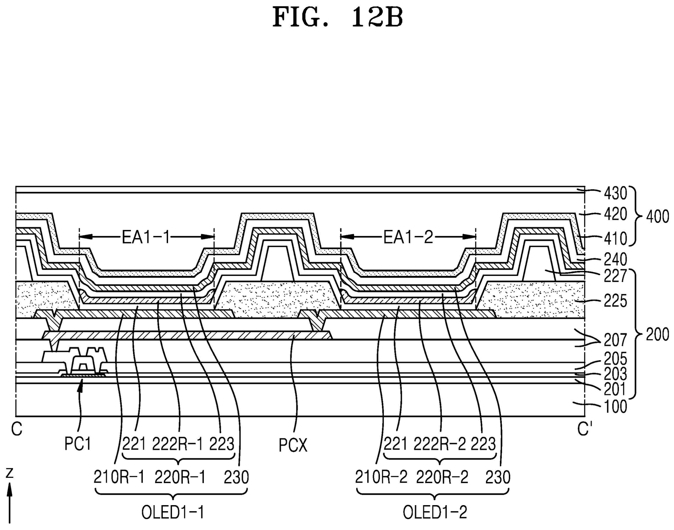

FIGS. 11A and 11B are plan views schematically illustrating the display area of the display panel of FIG. 6. FIGS. 12A and 12B are cross-sectional views schematically illustrating a portion of the display panel, taken along the line C-C' of FIG. 11A. Reference numerals of FIGS. 12A and 12B, which are the same as (e.g., equal to) reference numerals of FIGS. 10B and 10C, indicate same elements as elements of FIGS. 10B and 10C.

Referring to FIGS. 11A and 11B, a same number of display elements are arrayed on the display area DA (see FIG. 8), and the display area DA may include a plurality of unit areas PU arranged to be adjacent to each other on the display area DA.

Each of the unit areas PU may include three display elements. For example, each unit area PU may include the first organic light-emitting diode OLED1 that is a first display element, the second organic light-emitting diode OLED2 that is a second display element, and the third organic light-emitting diode OLED3 that is a third display element. The first organic light-emitting diode OLED1, the second organic light-emitting diode OLED2, and the third organic light-emitting diode OLED3 may emit light of different colors. For example, the first organic light-emitting diode OLED1 may emit red light, the second organic light-emitting diode OLED2 may emit green light, and the third organic light-emitting diode OLED3 may emit blue light.

In the case above, in one or more embodiments, one of the first organic light-emitting diode OLED1, the second organic light-emitting diode OLED2, and the third organic light-emitting diode OLED3 may include a distinguished display element. In particular, when it is assumed that one first organic light-emitting diode OLED1, one second organic light-emitting diode OLED2, and one third organic light-emitting diode OLED3 are arranged in a unit area PU, an organic light-emitting diode having a smallest aperture ratio from among one first organic light-emitting diode OLED1, one second organic light-emitting diode OLED2, and one third organic light-emitting diode OLED3 may be divided as two distinguished display elements and may be arranged in the unit area PU. In another embodiment, when a difference between a aperture ratio of an organic light-emitting diode having the smallest aperture ratio from among one first organic light-emitting diode OLED1, one second organic light-emitting diode OLED2, and one third organic light-emitting diode OLED3 and an aperture ratio of an organic light-emitting diode having the second-smallest aperture ratio from among one first organic light-emitting diode OLED1, one second organic light-emitting diode OLED2, and one third organic light-emitting diode OLED3 is around 10 %, the organic light-emitting diode having the second-smallest aperture ratio may be divided as two distinguished display elements and may be arranged in the unit area PU. Hereinafter, for convenience of descriptions, a case in which, when one first organic light-emitting diode OLED1, one second organic light-emitting diode OLED2, and one third organic light-emitting diode OLED3 are arranged in a unit area PU, an aperture ratio of each organic light-emitting diode may increase in order of the first organic light-emitting diode OLED1, the second organic light-emitting diode OLED2, and the third organic light-emitting diode OLED3 will be described in detail.

A case in which one first organic light-emitting diode OLED1, one second organic light-emitting diode OLED2, and one third organic light-emitting diode OLED3 are arranged in a unit area PU so as to determine an organic light-emitting diode to be divided as two distinguished display elements may be assumed. Here, respective aperture ratios of the first organic light-emitting diode OLED1, the second organic light-emitting diode OLED2, and the third organic light-emitting diode OLED3 arranged in the unit area PU may be determined. The aforementioned method of determining an aperture ratio of each organic light-emitting diode may correspond to a method of calculating a plan-shape area of an emission area of each organic light-emitting diode with respect to a plan-shape entire area of the unit area PU when each of a lifetime of an emission layer of each organic light-emitting diode and brightness of each organic light-emitting diode corresponds to suitable brightness (e.g., a preset brightness). For example, respective aperture ratios of the first organic light-emitting diode OLED1, the second organic light-emitting diode OLED2, and the third organic light-emitting diode OLED3 arranged in the unit area PU may correspond to a lifetime of an emission layer in an intermediate layer of each organic light-emitting diode. In detail, an emission area of an organic light-emitting diode including an emission layer whose lifetime is smaller than another emission layer may be increased, and a voltage applied between emission layers may be set to be lower than another organic light-emitting diode, so that brightness of the organic light-emitting diode in the unit area PU may correspond to the suitable brightness (e.g., the preset brightness). Also, an emission area of an organic light-emitting diode including an emission layer whose lifetime is greater than another emission layer may be decreased, and a voltage applied between emission layers may be set to be higher than another organic light-emitting diode, so that brightness of the organic light-emitting diode in the unit area PU may correspond to the suitable brightness (e.g., the preset brightness). In this regard, a voltage applied between emission layers may be within a suitable range (e.g., a preset range). Therefore, an aperture ratio of an organic light-emitting diode having the greatest lifetime of an emission layer may be minimum, and an aperture ratio of an organic light-emitting diode having the smallest lifetime of an emission layer may be maximum. In the case above, an aperture ratio of each organic light-emitting diode may be calculated as a ratio of plan-shape areas of respective emission areas of the first organic light-emitting diode OLED1, the second organic light-emitting diode OLED2, and the third organic light-emitting diode OLED3 to a constant area (e.g. a plan-shape entire area of the unit area PU). Also, when each organic light-emitting diode has the same plan-shape area of an emission area and the same voltage is applied, a lifetime of an emission layer may be measured as a time for brightness of an organic light-emitting diode to decrease to half.

In the case above, the first organic light-emitting diode OLED1 or the second organic light-emitting diode OLED2 may include a distinguished display element. Hereinafter, for convenience of descriptions, a case in which the first organic light-emitting diode OLED1 includes a distinguished display element will now be described in detail.

Two distinguished display elements may be arranged. For example, the first organic light-emitting diode OLED1 may include the first distinguished organic light-emitting diode OLED1-1 that is a first distinguished display element and the second distinguished organic light-emitting diode OLED1-2 that is a second distinguished display element. The first distinguished organic light-emitting diode OLED1-1, the second distinguished organic light-emitting diode OLED1-2, the second organic light-emitting diode OLED2, and the third organic light-emitting diode OLED3 may be arranged to be spaced (e.g., spaced apart) from each other on the unit area PU. In this regard, a first center Cr1 of a plan shape of a 1-1 emission area EA1-1 of the first distinguished organic light-emitting diode OLED1-1, a second center Cr2 of a plan shape of a 1-2 emission area EA1-2 of the second distinguished organic light-emitting diode OLED1-2, a third center Cg of a plan shape of a second emission area EA2 of the second organic light-emitting diode OLED2, and a fourth center Cb of a plan shape of a third emission area EA3 of the third organic light-emitting diode OLED3 may each be arranged at a vertex of an arbitrary quadrangle. Here, the quadrangle may be a square. Also, one side of the quadrangle may be 1/2 of a side length of a plan shape of the unit area PU. The plan shape of the unit area PU may be a square.

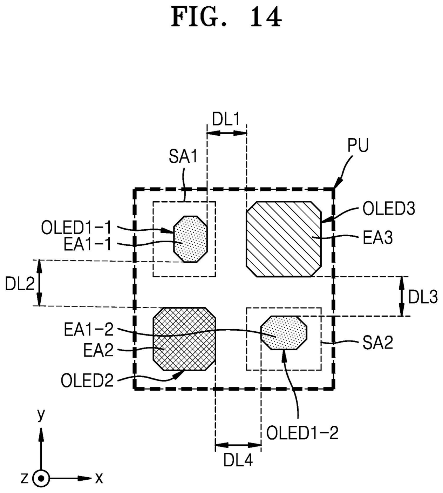

One side (e.g., long side or short side) of the plan shape of the 1-1 emission area EA1-1 of the first distinguished organic light-emitting diode OLED1-1 and/or one side (e.g., long side or short side) of the plan shape of the 1-2 emission area EA1-2 of the second distinguished organic light-emitting diode OLED1-2 may be arranged within a distance between two parallel sides of the plan shape of the second emission area EA2 of the second organic light-emitting diode OLED2 and/or two parallel sides of the plan shape of the third emission area EA3 of the third organic light-emitting diode OLED3. That is, similar to what is shown in FIG. 14 to be described below, the plan shape of the 1-1 emission area EA1-1 of the first distinguished organic light-emitting diode OLED1-1 and/or the plan shape of the 1-2 emission area EA1-2 of the second distinguished organic light-emitting diode OLED1-2 may be arranged within an arbitrary area formed when an arbitrary straight line extending from one side of the plan shape of the second emission area EA2 of the second organic light-emitting diode OLED2 crosses an arbitrary straight line extending from one side of the plan shape of the third emission area EA3 of the third organic light-emitting diode OLED3.

In the case above, the first center Cr1 and the third center Cg may be arranged on a straight line with respect to each other. Also, the first center Cr1 and the fourth center Cb may be arranged on a straight line with respect to each other. The second center Cr2 and the third center Cg may be arranged on a straight line with respect to each other. Also, the second center Cr2 and the fourth center Cb may be arranged on a straight line with respect to each other. In this regard, a straight line passing through the first center Cr1 and the third center Cg and a straight line passing through the second center Cr2 and the fourth center Cb may be parallel to each other. Also, a straight line passing through the second center Cr2 and the third center Cg and a straight line passing through the first center Cr1 and the fourth center Cb may be parallel to each other. The straight line passing through the first center Cr1 and the third center Cg and the straight line passing through the second center Cr2 and the fourth center Cb may trisect one side of the plan shape of the unit area PU. Also, the straight line passing through the second center Cr2 and the third center Cg and the straight line passing through the first center Cr1 and the fourth center Cb may trisect another side of the plan shape of the unit area PU.

The first center Cr1 and the second center Cr2 may be arrayed in a serpentine shape or a zigzag shape along one direction. Also, the first center Cr1 or the second center Cr2 respectively arranged in adjacent unit areas PU may be arranged on a straight line. Also, the straight line passing through the first center Cr1 and the fourth center Cb and the straight line passing through the first center Cr1 and the third center Cg may be perpendicular to each other. The straight line passing through the second center Cr2 and the fourth center Cb and the straight line passing through the second center Cr2 and the third center Cg may be perpendicular to each other.

The first distinguished organic light-emitting diode OLED1-1 and the second distinguished organic light-emitting diode OLED1-2 may be arranged in a diagonal direction with respect to each other about a center of the unit area PU. For example, the first distinguished organic light-emitting diode OLED1-1, the third organic light-emitting diode OLED3, the second distinguished organic light-emitting diode OLED1-2, and the second organic light-emitting diode OLED2 may be sequentially arranged in a clockwise direction, according to FIGS. 11A and 11B. In this case, the second organic light-emitting diode OLED2 and the third organic light-emitting diode OLED3 may be arranged in a diagonal direction with respect to each other about the center of the unit area PU.

In this case, plan shapes of a 1-1 emission layer 222R-1, a 1-2 emission layer 222R-2, a second emission layer 222G, and a third emission layer 222B may respectively correspond to plan shapes of the 1-1 emission area EA1-1, the 1-2 emission area EA1-2, the second emission area EA2, and the third emission area EA3. Here, the plan shapes of the 1-1 emission layer 222R-1, the 1-2 emission layer 222R-2, the second emission layer 222G, and the third emission layer 222B may be respectively greater than the plan shapes of the 1-1 emission area EA1-1, the 1-2 emission area EA1-2, the second emission area EA2, and the third emission area EA3.

In particular, in the case above, the 1-1 emission layer 222R-1 and the 1-2 emission layer 222R-2 may be arranged to be misaligned with respect to each other about the center of the unit area PU, and an arbitrary straight line extending from a long side of the 1-1 emission layer 222R-1 and an arbitrary straight line extending from a long side of the 1-2 emission layer 222R-2 may be arranged to be perpendicular to each other, so that a total sum of an aperture ratio of the first distinguished organic light-emitting diode OLED1-1 and an aperture ratio of the second distinguished organic light-emitting diode OLED1-2 in which the 1-1 emission layer 222R-1 and the 1-2 emission layer 222R-2 are respectively arranged may be ensured (e.g., maximally ensured).

In one or more embodiments, when a difference between an aperture ratio of the first organic light-emitting diode OLED1 and an aperture ratio of the second organic light-emitting diode OLED2 is equal to or less than 10 %, only one first organic light-emitting diode OLED1 may be arranged in the unit area PU, and the second organic light-emitting diode OLED2 may include a third distinguished organic light-emitting diode that is a first distinguished display element and a fourth distinguished organic light-emitting diode that is a second distinguished display element. Here, a relation between the first organic light-emitting diode OLED1, the third distinguished organic light-emitting diode, the fourth distinguished organic light-emitting diode, and the third organic light-emitting diode OLED3 may be equal or similar to an aforementioned relation between the second organic light-emitting diode OLED2, the first distinguished organic light-emitting diode OLED1-1, the second distinguished organic light-emitting diode OLED1-2, and the third organic light-emitting diode OLED3.

Referring to FIGS. 12A and 12B, the first distinguished organic light-emitting diode OLED1-1 may include a 1-1 sub-pixel electrode 210R-1, a 1-1 intermediate layer 220R-1, and the opposite electrode 230. In this regard, the 1-1 intermediate layer 220R-1 may include the first common layer 221, the 1-1 emission layer 222R-1, and the second common layer 223. A plan shape of the 1-1 emission layer 222R-1 may be greater than that of the 1-1 emission area EA1-1. The second distinguished organic light-emitting diode OLED1-2 may include a 1-2 sub-pixel electrode 210R-2, a 1-2 intermediate layer 220R-2, and the opposite electrode 230. In this regard, the 1-2 intermediate layer 220R-2 may include the first common layer 221, the 1-2 emission layer 222R-2, and the second common layer 223. A plan shape of the 1-2 emission layer 222R-2 may be greater than that of the 1-2 emission area EA1-2. In the case above, the 1-1 emission layer 222R-1 and the 1-2 emission layer 222R-2 may include the same material.

A plan shape of the 1-1 emission area EA1-1 of the first distinguished organic light-emitting diode OLED1-1 and a plan shape of the 1-2 emission area EA1-2 of the second distinguished organic light-emitting diode OLED1-2 may have an octagonal shape. Each of the plan shape of the 1-1 emission area EA1-1 of the first distinguished organic light-emitting diode OLED1-1 and the plan shape of the 1-2 emission area EA1-2 of the second distinguished organic light-emitting diode OLED1-2 may have a long side and a short side. In the case above, an arbitrary straight line extending from the long side of the plan shape of the 1-1 emission area EA1-1 of the first distinguished organic light-emitting diode OLED1-1 may cross an arbitrary straight line extending from the long side of the plan shape of the 1-2 emission area EA1-2 of the second distinguished organic light-emitting diode OLED1-2. In particular, an arbitrary straight line extending from a long side of the plan shape of the 1-1 emission area EA1-1 of the first distinguished organic light-emitting diode OLED1-1 may be perpendicular to the arbitrary straight line extending from the long side of the plan shape of the 1-2 emission area EA1-2 of the second distinguished organic light-emitting diode OLED1-2. By doing so, light emitted from each of the first distinguished organic light-emitting diode OLED1-1 and the second distinguished organic light-emitting diode OLED1-2 may be viewed at various angles outside the display panel.

As shown in FIG. 11A, a first distance DL1 from a long side of the plan shape of the 1-1 emission area EA1-1 of the first distinguished organic light-emitting diode OLED1-1 to the plan shape of the third emission area EA3 of the third organic light-emitting diode OLED3 which faces the long side of the plan shape of the 1-1 emission area EA1-1 of the first distinguished organic light-emitting diode OLED1-1, a second distance DL2 from a short side of the plan shape of the 1-1 emission area EA1-1 of the first distinguished organic light-emitting diode OLED1-1 to the plan shape of the second emission area EA2 of the second organic light-emitting diode OLED2 which faces the short side of the plan shape of the 1-1 emission area EA1-1 of the first distinguished organic light-emitting diode OLED1-1, a third distance DL3 from a long side of the plan shape of the 1-2 emission area EA1-2 of the second distinguished organic light-emitting diode OLED1-2 to the plan shape of the third emission area EA3 of the third organic light-emitting diode OLED3 which faces the long side of the plan shape of the 1-2 emission area EA1-2 of the second distinguished organic light-emitting diode OLED1-2, and a fourth distance DL4 from a short side of the plan shape of the 1-2 emission area EA1-2 of the second distinguished organic light-emitting diode OLED1-2 to the plan shape of the second emission area EA2 of the second organic light-emitting diode OLED2 which faces the short side of the plan shape of the 1-2 emission area EA1-2 of the second distinguished organic light-emitting diode OLED1-2 may be all equal. Each display element described above may include an emission layer. In this regard, a plan shape of each emission layer may completely block a plan shape of an emission area of each organic light-emitting diode. When the first distance DL1, the second distance DL2, the third distance DL3, and the fourth distance DL4 are equal, an emission area of each organic light-emitting diode may be ensured (e.g., maximally ensured), and an emission layer of each organic light-emitting diode may not be arranged in an emission area of each adjacent organic light-emitting diode. The first distance DL1, the second distance DL2, the third distance DL3, and the fourth distance DL4 may be equal not only in one unit area PU but also equal between adjacent unit areas PU and/or in another unit area PU.

As shown in FIGS. 11A, 11B, 12A and 12B, a sub-pixel circuit may be arranged in a unit area PU. For example, the sub-pixel circuit may include a first sub-pixel circuit PC1 for controlling driving of the first distinguished organic light-emitting diode OLED1-1 and the second distinguished organic light-emitting diode OLED1-2 by being connected to the first distinguished organic light-emitting diode OLED1-1 and the second distinguished organic light-emitting diode OLED1-2, a second sub-pixel circuit PC2 for controlling driving of the second organic light-emitting diode OLED2 by being connected to the second organic light-emitting diode OLED2, and a third sub-pixel circuit PC3 for controlling driving of the third organic light-emitting diode OLED3 by being connected to the third organic light-emitting diode OLED3. In the case above, the first distinguished organic light-emitting diode OLED1-1 and the second distinguished organic light-emitting diode OLED1-2 may emit light of the same color and may be driven equally with respect to each other by the first sub-pixel circuit PC1. That is, when the first distinguished organic light-emitting diode OLED1-1 is driven and emits red light, the second distinguished organic light-emitting diode OLED1-2 may emit red light during a period of time in which the first distinguished organic light-emitting diode OLED1-1 emits red light.

The first sub-pixel circuit PC1 may be electrically connected to the first distinguished organic light-emitting diode OLED1-1 and the second distinguished organic light-emitting diode OLED1-2.

In one or more embodiments, the 1-1 sub-pixel electrode 210R-1 of the first distinguished organic light-emitting diode OLED1-1 and the 1-2 sub-pixel electrode 210R-2 of the second distinguished organic light-emitting diode OLED1-2 may be individually connected to a thin-film transistor of the first sub-pixel circuit PC1. In this regard, the 1-1 sub-pixel electrode 210R-1 of the first distinguished organic light-emitting diode OLED1-1 may be directly connected to the first sub-pixel circuit PC1 as shown in FIG. 12A, and the 1-2 sub-pixel electrode 210R-2 of the second distinguished organic light-emitting diode OLED1-2 may be directly connected to the first sub-pixel circuit PC1 in a similar manner by which the 1-1 sub-pixel electrode 210R-1 shown in FIG. 12A is directly connected to the first sub-pixel circuit PC1.

In one or more embodiments, the 1-1 sub-pixel electrode 210R-1 of the first distinguished organic light-emitting diode OLED1-1 may be directly connected to the first sub-pixel circuit PC1 as shown in FIG. 12A, and the 1-2 sub-pixel electrode 210R-2 of the second distinguished organic light-emitting diode OLED1-2 may be connected to an electrode of a similar shape to a sub-pixel connection electrode PCX shown in FIG. 12B, and thus, may be separately connected to the first sub-pixel circuit PC1 via the electrode, without being connected to the 1-1 sub-pixel electrode 210R-1.

In one or more embodiments, as shown in FIG. 12A, one of a sub-pixel electrode of the first distinguished organic light-emitting diode OLED1-1 or a sub-pixel electrode of the second distinguished organic light-emitting diode OLED1-2 may be connected to the thin-film transistor of the first sub-pixel circuit PC1, and another one of the 1-1 sub-pixel electrode 210R-1 of the first distinguished organic light-emitting diode OLED1-1 or the 1-2 sub-pixel electrode 210R-2 of the second distinguished organic light-emitting diode OLED1-2 may be connected to one of the 1-1 sub-pixel electrode 210R-1 of the first distinguished organic light-emitting diode OLED1-1 or the 1-2 sub-pixel electrode 210R-2 of the second distinguished organic light-emitting diode OLED1-2 via the sub-pixel connection electrode PCX. In this regard, the sub-pixel connection electrode PCX may have various shapes. For example, in one or more embodiments, as shown in FIG. 12A, the sub-pixel connection electrode PCX may have a shape on which a portion of the one of the 1-1 sub-pixel electrode 210R-1 of the first distinguished organic light-emitting diode OLED1-1 or the 1-2 sub-pixel electrode 210R-2 of the second distinguished organic light-emitting diode OLED1-2 extends to another one of the 1-1 sub-pixel electrode 210R-1 of the first distinguished organic light-emitting diode OLED1-1 or the 1-2 sub-pixel electrode 210R-2 of the second distinguished organic light-emitting diode OLED1-2. In one or more embodiments, as shown in FIG. 12B, the sub-pixel connection electrode PCX may be arranged in the planarization layer 207 (see FIGS. 10B and 10C) arranged under the 1-1 sub-pixel electrode 210R-1 of the first distinguished organic light-emitting diode OLED1-1 and the 1-2 sub-pixel electrode 210R-2 of the second distinguished organic light-emitting diode OLED1-2. In this case, the 1-1 sub-pixel electrode 210R-1 of the first distinguished organic light-emitting diode OLED1-1 and the 1-2 sub-pixel electrode 210R-2 of the second distinguished organic light-emitting diode OLED1-2 may be connected to the sub-pixel connection electrode PCX, and the sub-pixel connection electrode PCX may be connected to the thin-film transistor of the first sub-pixel circuit PC1. In this regard, the planarization layer 207 may be provided in plural, and the sub-pixel connection electrode PCX may be arranged between the plurality of planarization layers 207. In one or more embodiments, one of the 1-1 sub-pixel electrode 210R-1 of the first distinguished organic light-emitting diode OLED1-1 or the 1-2 sub-pixel electrode 210R-2 of the second distinguished organic light-emitting diode OLED1-2 may be connected to the thin-film transistor of the first sub-pixel circuit PC1, and the sub-pixel connection electrode PCX may connect one of the 1-1 sub-pixel electrode 210R-1 of the first distinguished organic light-emitting diode OLED1-1 or the 1-2 sub-pixel electrode 210R-2 of the second distinguished organic light-emitting diode OLED1-2 to the other one of the 1-1 sub-pixel electrode 210R-1 of the first distinguished organic light-emitting diode OLED1-1 or the 1-2 sub-pixel electrode 210R-2 of the second distinguished organic light-emitting diode OLED1-2.

The sub-pixel connection electrode PCX may be arranged not to overlap the second organic light-emitting diode OLED2 and the third organic light-emitting diode OLED3. For example, the sub-pixel connection electrode PCX may extend to pass through a gap between the second organic light-emitting diode OLED2 and the third organic light-emitting diode OLED3, and thus, may connect the first distinguished organic light-emitting diode OLED1-1 to the second distinguished organic light-emitting diode OLED1-2. In one or more embodiments, the sub-pixel connection electrode PCX may connect the first distinguished organic light-emitting diode OLED1-1 to the second distinguished organic light-emitting diode OLED1-2 by extending along an edge of a plan shape of the unit area PU so as to bypass the second organic light-emitting diode OLED2 and/or the third organic light-emitting diode OLED3 (e.g., see FIGS.11A and 11B).

The plan shape of the second emission area EA2 of the second organic light-emitting diode OLED2 and the plan shape of the third emission area EA3 of the third organic light-emitting diode OLED3 may be a square. In this regard, the plan shape of the second emission area EA2 of the second organic light-emitting diode OLED2 and the plan shape of the third emission area EA3 of the third organic light-emitting diode OLED3 may have a chamfered shape.

In one or more embodiments, when a difference between an aperture ratio of the first organic light-emitting diode OLED1 and an aperture ratio of the second organic light-emitting diode OLED2 is equal to or less than 10 %, only one first organic light-emitting diode OLED1 may be arranged in the unit area PU, and the second organic light-emitting diode OLED2 may include a third distinguished organic light-emitting diode that is a first display distinguished element and a fourth distinguished organic light-emitting diode that is a second distinguished display element. In this regard, the third distinguished organic light-emitting diode and the fourth distinguished organic light-emitting diode may include the similar structure to the first distinguished organic light-emitting diode OLED1-1 and the second distinguished organic light-emitting diode OLED1-2.

Therefore, when it is assumed that each of three display elements emitting different colors via the aforementioned structure is arranged in one unit area PU, a display element having the smallest aperture ratio or having an aperture ratio whose difference to the smallest aperture ratio is less than 10 % is divided into two distinguished display elements and arranged in a unit area PU in the display panel and the display apparatus, so that an emission area of all display elements in the unit area PU may be increased. Also, when the three display elements are arranged in the display panel and the display apparatus, the display element having the smallest aperture ratio or having an aperture ratio whose difference to the smallest aperture ratio is less than 10 % is divided into the two distinguished display elements and arranged, so that brightness of the corresponding display element may be higher than the brightness before being divided into the two distinguished display elements in the unit area PU.

In one or more embodiments, it is also possible that not the first organic light-emitting diode OLED1 but the second organic light-emitting diode OLED2 may include two distinguished display elements as described above. Here, only one first organic light-emitting diode OLED1 may be arranged in the unit area PU. Also, descriptions of shapes, a distance, and centers of the two distinguished display elements that are the second organic light-emitting diode OLED2 may be similar to those of the first distinguished organic light-emitting diode OLED1-1 and the second distinguished organic light-emitting diode OLED1-2, which are described above. In this case, a plan shape of an emission area of each of the first organic light-emitting diode OLED1 and the third organic light-emitting diode OLED3 may have a chamfered square shape.

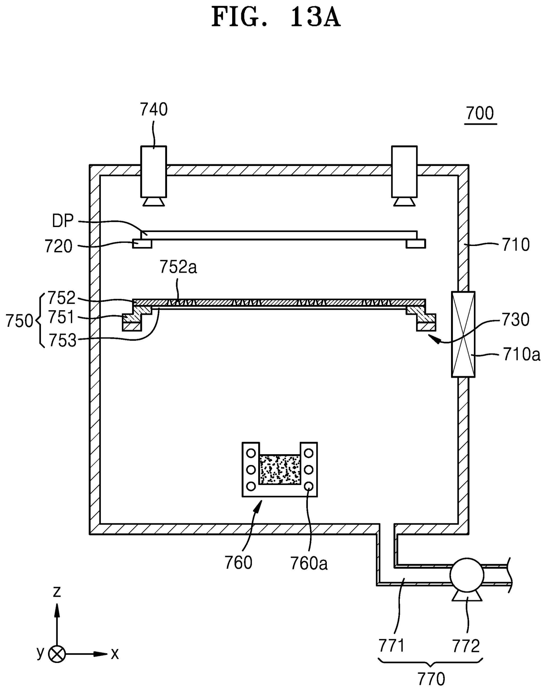

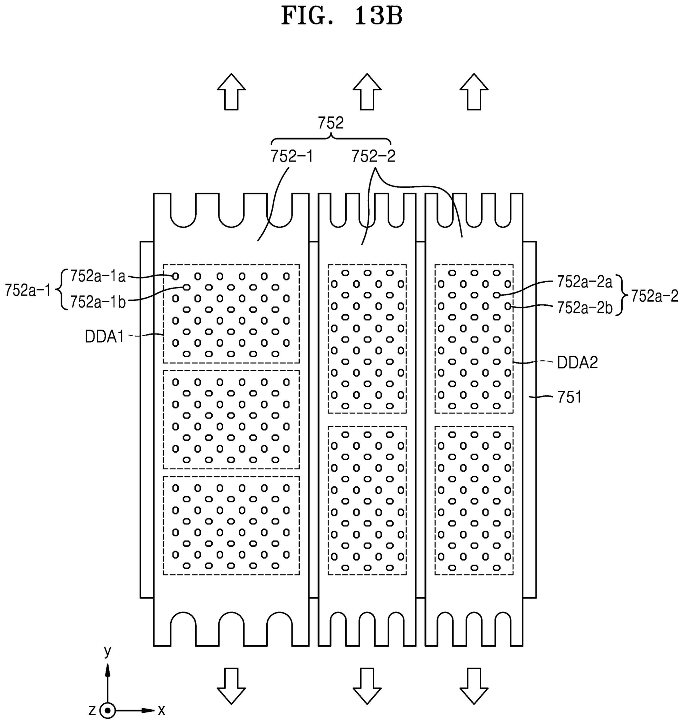

FIG. 13A is a cross-sectional view schematically illustrating a manufacturing apparatus 700 of a display panel according to one or more embodiments. FIG. 13B is a plan view schematically illustrating a mask assembly shown in FIG. 13A.

Referring to FIGS. 13A and 13B, a manufacturing apparatus 700 of a display panel may include a chamber 710, a mask assembly 750, a deposition source 760, a first support portion 720, a second support portion 730, a pressure adjustment portion 770, and a vision portion 740.

The mask assembly 750 may include a mask frame 751, a mask sheet 752, and a support frame 753.

A plurality of frames connected to each other or one frame may be formed as the mask frame 751. In this regard, the mask frame 751 may be formed while having penetrated therein. In particular, the mask frame 751 may be formed while having its center portion completely penetrated. In the mask frame 751, the center portion may be formed in a grid form to have its portion penetrated.

The mask sheet 752 may be arranged on the mask frame 751. In this regard, the mask sheet 752 may be formed as one body to completely block one surface of the mask frame 751. In one or more embodiments, the mask sheet 752 may be provided in plural, and the plurality of mask sheets 752 may be arranged to be adjacent to each other on the mask frame 751, and thus, may completely block one surface of the mask frame 751. In particular, the plurality of mask sheets 752 may completely block open portions of the mask frame 751. Hereinafter, for convenience of descriptions, a case in which the mask sheet 752 is provided in plural will be mainly described in detail.

The plurality of mask sheets 752 may include a first mask sheet 752-1 and a second mask sheet 752-2. The first mask sheet 752-1 may include a plurality of first pattern portions DDA1. The plurality of first pattern portions DDA1 may include a pair of first openings 752a-1 arrayed in different directions. In this regard, the first opening 752a-1 may include a first pattern opening 752a-1a and a second pattern opening 752a-1b. The first pattern opening 752a-1a and the second pattern opening 752a-1b may have an octagonal shape or a rectangular shape, each having a long side and a short side. An arbitrary straight line extending from a long side of the first pattern opening 752a-1a may be perpendicular to an arbitrary straight line extending from a long side of the second pattern opening 752a-1b. Also, the first pattern opening 752a-1a and the second pattern opening 752a-1b may be arrayed in a zigzag shape or a serpentine shape along one direction. The shape of the plurality of first pattern portions DDA1 is shown as a rectangle, but is not limited thereto, and may have various shapes including a non-quadrangle polygon, a circle, an oval, etc. One of the long side of the first pattern opening 752a-1a or the long side of the second pattern opening 752a-1b may be arrayed to be parallel to a tensile direction of the first mask sheet 752-1, and the other one of the long side of the first pattern opening 752a-1a or the long side of the second pattern opening 752a-1b may be arrayed to be perpendicular to a tensile direction of the first mask sheet 752-1.

The second mask sheet 752-2 may include a plurality of second pattern portions DDA2. The plurality of second pattern portions DDA2 may include a pair of second openings 752a-2 arrayed in different directions. The second opening 752a-2 may include a third pattern opening 752a-2a and a fourth pattern opening 752a-2b. Here, the second pattern portion DDA2 may be similar to the first pattern portion DDA1 but may be different in a direction of a long side, compared to the first pattern portion DDA1. Also, the third pattern opening 752a-2a may be equal to the second pattern opening 752a-1b, and the fourth pattern opening 752a-2b may be equal to the first pattern opening 752a-1a. Here, the first opening 752a-1 and the second opening 752a-2 may be collectively referred to as openings 752a..

In the case above, the first pattern portion DDA1 and the second pattern portion DDA2 may form different display areas of the display panel. That is, one mask assembly 750 may be arranged to correspond to one base substrate and may pass a deposition material. In this regard, the deposition material may pass through the plurality of first pattern portions DDA1 and the plurality of second pattern portions DDA2 and may be deposited on the base substrate. The deposition material deposited on the base substrate may pass through one first pattern portion DDA1 or one second pattern portion DDA2, and thus, may form the 1-1 emission layer 222R-1 or the 1-2 emission layer 222R-2 which is arranged in a display area of one display panel.

In the case above, tensile directions of the first mask sheet 752-1 and the second mask sheet 752-2 may be equal to each other. Here, one first pattern opening 752a-1a and one second pattern opening 752a-1b may form the 1-1 emission layer 222R-1 and the 1-2 emission layer 222R-2 which are arranged in one unit area PU described with reference to FIGS. 11A and 11B. Also, one third pattern opening 752a-2a and one fourth pattern opening 752a-2b may form the 1-2 emission layer 222R-2 and the 1-1 emission layer 222R-1 which are arranged in one unit area PU described with reference to FIGS. 11A and 11B. In this case, an entire area of the 1-1 emission layer 222R-1 and the 1-2 emission layer 222R-2 arranged in one unit area PU may be equal in both the first mask sheet 752-1 and the second mask sheet 752-2. That is, although directions of pattern openings arranged in each of the first mask sheet 752-1 and the second mask sheet 752-2 are not equal, a tensile force applied to the first mask sheet 752-1 is equal to a tensile force applied to the second mask sheet 752-2, deformation in the first pattern opening 752a-1a and deformation in the second pattern opening 752a-1b which occur when the tensile force is applied to the first mask sheet 752-1 may be nearly similar to deformation in the fourth pattern opening 752a-2b and deformation in the third pattern opening 752a-2a which occur when the tensile force is applied to the second mask sheet 752-2. Accordingly, when a deposition material is arranged in a plurality of display areas via pattern portions arrayed in different direction in one base substrate, an entire area of the 1-1 emission layer 222R-1 and the 1-2 emission layer 222R-2 arranged in a unit area PU of each display area may be uniform in the plurality of display areas arranged in one base substrate. Also, in the case above, as described with reference to FIGS. 11A and 11B, as a distance from the long side of the plan shape of the 1-1 emission area EA1-1 to the plan shape of the third emission area EA3, a distance from the short side of the plan shape of the 1-1 emission area EA1-1 to the plan shape of the second emission area EA2, a distance from the long side of the plan shape of the 1-2 emission area EA1-2 to the plan shape of the third emission area EA3, and a distance from the short side of the plan shape of the 1-2 emission area EA1-2 to the plan shape of the second emission area EA2 are all equal, even when a direction of each pattern opening is rotated by N multiple of 90 degrees (where N is a natural number excluding 0), a result described above may be deduced.

In the case above, the first mask sheet 752-1 or the second mask sheet 752-2 may include the first pattern portion DDA1 and the second pattern portion DDA2. Even in this case, an entire area of the 1-1 emission layer 222R-1 and the 1-2 emission layer 222R-2 arranged in unit areas of a plurality of display panels which are manufactured via the first mask sheet 752-1 or the second mask sheet 752-2 may be uniformly maintained in each of the plurality of display panels which are manufactured via the first mask sheet 752-1 or the second mask sheet 752-2.

The mask assembly 750 may include the support frame 753 arranged at the mask frame 751. Here, the support frame 753 may be arranged to face the mask sheet 752, and may be arranged between neighboring mask sheets 752. Also, the support frame 753 may be arranged in a direction perpendicular to a longitudinal direction of the mask sheet 752. The support frame 753 may not only prevent deformation of the mask frame 751 but also prevent the mask sheet 752 from sagging due to the load.

The chamber 710 may have a space formed therein, and may be formed to be partly open. Here, a gate valve 710a is arranged in the open portion of the chamber 710 so as to selectively open or close the open portion of the chamber 710.

The deposition source 760 may include a deposition material to be formed as a 1-1 emission layer and a 1-2 emission layer.

The deposition source 760 may be arranged to face the mask frame 751, and a portion of the deposition source 760 which is arranged to face the mask frame 751 may be open. Also, the deposition source 760 may include a first heater 760a to apply heat to the deposition material.

The first support portion 720 may support a base substrate of a display substrate DP. The display substrate DP may indicate a stack structure from the base substrate (e.g., the substrate 100 of FIGS. 10B and 10C) to the first common layer 221 of FIGS. 10B and 10C. The first support portion 720 may be formed as various shapes. For example, the first support portion 720 may include a shuttle, an electrostatic chuck, a contact chuck, etc., which are arranged in the chamber 710. In one or more embodiments, a separate frame may be included and arranged in the chamber 710. However, hereinafter, for convenience of descriptions, a case in which the first support portion 720 includes a separate frame will be described in detail.

On the base substrate of the display substrate DP as described above, the deposition material may be deposited in a plurality of areas spaced (e.g., spaced apart) from each other. After deposition is completed, the base substrate of the display substrate DP may be separated into a plurality of portions to form the substrate 100 of FIGS. 10B and 10C. In one or more embodiments, the deposition material may be deposited on an entire surface of the base substrate of the display substrate DP. In this case, the first pattern opening 752a-1a and the second pattern opening 752a-1b or the third pattern opening 752a-2a and the fourth pattern opening 752a-2b may be deposited on an entire surface of the mask sheet 752. In particular, in the case above, after the deposition is completed, the base substrate of the display substrate DP may form one substrate 100 of FIGS. 10B and 10C. However, hereinafter, for convenience of descriptions, a case in which the deposition material is deposited in the plurality of areas spaced (e.g., spaced apart) from each other on the base substrate of the display substrate DP will be described in detail.

The second support portion 730 may be arranged between the first support portion 720 and the deposition source 760. In this regard, the second support portion 730 may support the mask assembly 750 by placing the mask assembly 750 thereon. The second support portion 730 may vary placement of the mask assembly 750 within a small range, and thus, may array the mask assembly 750 and the base substrate of the display substrate DP.

The first support portion 720 and the second support portion 730 may be separate from each other and may operate independently. In one or more embodiments, the first support portion 720 and the second support portion 730 may be integrally formed and may concurrently (e.g., simultaneously) move. However, hereinafter, for convenience of descriptions, a case in which the first support portion 720 and the second support portion 730 are separate from each other and independently operate will be described in detail.

The pressure adjustment portion 770 may be connected to the chamber 710 and may constantly maintain a pressure in the chamber 710. Here, the pressure adjustment portion 770 may include a connection pipe 771 connected to the chamber 710 and a pump 772 arranged at the connection pipe 771.

The vision portion 740 may include a camera. The vision portion 740 may photograph a position of the base substrate of the display substrate DP and a position of the mask assembly 750, and thus, may provide data required to array the base substrate of the display substrate DP and the mask assembly 750.

Regarding an operation of the manufacturing apparatus 700 of the display panel, the pressure adjustment portion 770 may adjust the pressure in the chamber 710 to be similar to a barometric pressure. The gate valve 710a may be open to open the open portion of the chamber 710.

When the gate valve 710a is open, the base substrate of the display substrate DP and the mask assembly 750 may be inserted into the chamber 710 from the outside of the chamber 710. In this regard, the base substrate of the display substrate DP and the mask assembly 750 may be moved by a robot arm, a shuttle, etc. In one or more embodiments, the first support portion 720 and the second support portion 730 are formed in a shuttle form, so that the base substrate of the display substrate DP and the mask assembly 750 may be placed at the first support portion 720 and the second support portion 730 in the outside of the chamber 710, and then, the first support portion 720 and the second support portion 730 may be moved into the chamber 710. In this regard, each of the first support portion 720 and the second support portion 730 may be a shuttle, or the first support portion 720 and the second support portion 730 may be one body in a shuttle form.

When the base substrate of the display substrate DP and the mask assembly 750 are inserted into the chamber 710, the gate valve 710a may be driven to close the chamber 710, and the pressure adjustment portion 770 may operate to maintain the pressure in the chamber 710 to be an almost vacuum state. Also, the deposition source 760 may vaporize or sublimate the deposition material to be deposited on the base substrate of the display substrate DP via the mask assembly 750. The deposition material may be deposited in a suitable pattern (e.g., a preset pattern) on the base substrate of the display substrate DP by passing through the first opening 752a-1 and the second opening 752a-2 on the mask sheet 752.

Accordingly, as pattern openings arrayed in different directions are arranged in each pattern portion, the manufacturing apparatus 700 of the display panel may constantly maintain a total area of deposition material patterns deposited in a suitable area (e.g., a preset area) of a base substrate, via each pattern portion, regardless of a tensile direction of a mask sheet.

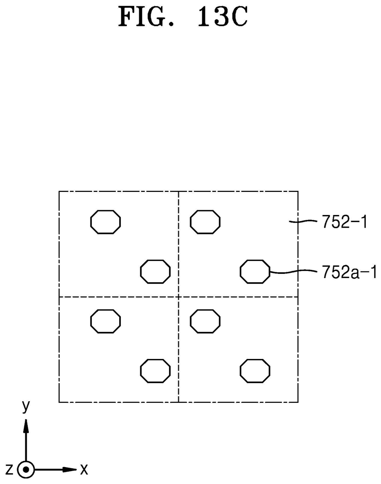

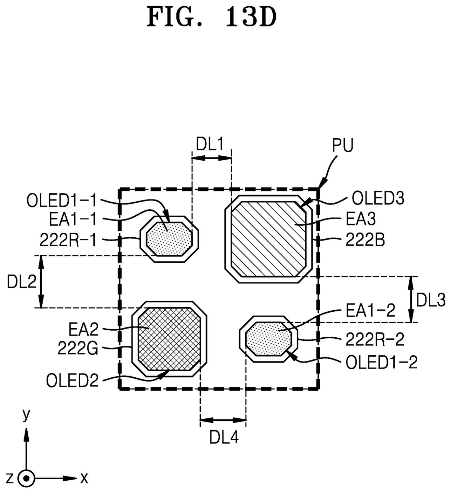

FIG. 13C is a plan view illustrating a portion of a mask sheet for the manufacture of a comparative example with respect to the invention. FIG. 13D is a plan view illustrating a portion of a display panel manufactured by a scheme shown in FIG. 13C.

Referring to FIGS. 13C and 13D, unlike embodiments of the present invention, in the comparative example with respect to the embodiments, the first opening 752a-1 may not include a first pattern opening and may include a second pattern opening. When a long side of the first opening 752a-1 is arrayed in a direction perpendicular to a tensile direction of the first mask sheet 752-1 or a tensile direction of a second mask sheet, as shown in FIG. 13C, a deposition material having passed through the first opening 752a-1 may be arranged on a base substrate so as to form the 1-1 emission layer 222R-1 and the 1-2 emission layer 222R-2.

In this case, the first distance DL1 from the short side of the plan shape of the 1-1 emission area EA1-1 of the first distinguished organic light-emitting diode OLED1-1 to the plan shape of the third emission area EA3 of the third organic light-emitting diode OLED3 which faces the short side of the plan shape of the 1-1 emission area EA1-1 of the first distinguished organic light-emitting diode OLED1-1 may be decreased, compared to what is described with reference to FIGS. 11A and 11B. In this regard, the second distance DL2 from the long side of the plan shape of the 1-1 emission area EA1-1 of the first distinguished organic light-emitting diode OLED1-1 to the plan shape of the second emission area EA2 of the second organic light-emitting diode OLED2 which faces the long side of the plan shape of the 1-1 emission area EA1-1 of the first distinguished organic light-emitting diode OLED1-1, the third distance DL3 from the long side of the plan shape of the 1-2 emission area EA1-2 of the second distinguished organic light-emitting diode OLED1-2 to the plan shape of the third emission area EA3 of the third organic light-emitting diode OLED3 which faces the long side of the plan shape of the 1-2 emission area EA1-2 of the second distinguished organic light-emitting diode OLED1-2, and the fourth distance DL4 from a short side of the plan shape of the 1-2 emission area EA1-2 of the second distinguished organic light-emitting diode OLED1-2 to the plan shape of the second emission area EA2 of the second organic light-emitting diode OLED2 which faces the short side of the plan shape of the 1-2 emission area EA1-2 of the second distinguished organic light-emitting diode OLED1-2 may be all equal to what are described with reference to FIGS. 11A and 11B.

In the case above, the first distance DL1 may be smaller than each of the second distance DL2 to the fourth distance DL4, and when the 1-1 emission layer 222R-1 is arranged, a problem may occur because the 1-1 emission layer 222R-1 overlaps the third emission area EA3. In particular, in the case above, in order to sufficiently ensure the first distance DL1, a size of the first opening 752a-1 used to form the 1-1 emission layer 222R-1 has to be decreased or a pattern opening of a mask assembly used to form the third emission layer 222B has to be formed small. In this case, the 1-1 emission layer 222R-1 and the third emission layer 222B are mixed with each other in the third emission area EA3 or a size of the third emission layer 222B has to be decreased, so that an aperture ratio of the third organic light-emitting diode OLED3 may be decreased, compared to what is described with reference to FIGS. 11A and 11B. In particular, in this case, not only a resolution of the display panel may deteriorate but also an operation of the display panel may have a problem.

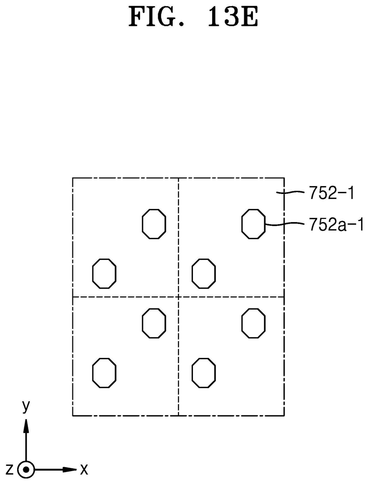

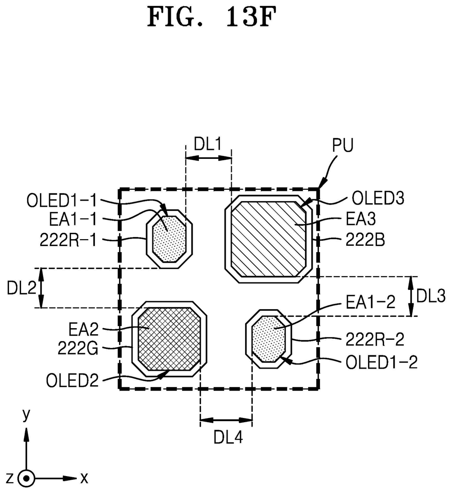

FIG. 13E is a plan view illustrating a portion of a mask sheet for the manufacture of a comparative example with respect to the invention. FIG. 13F is a plan view illustrating a portion of a display panel manufactured by a scheme shown in FIG. 13E.

Referring to FIGS. 13E and 13F, unlike embodiments of the present invention, in the comparative example with respect to the embodiments, the first opening 752a-1 may not include a second pattern opening and may include a first pattern opening. When a long side of the first opening 752a-1 is arrayed in a direction perpendicular to a tensile direction of the first mask sheet 752-1 or a tensile direction of a second mask sheet, as shown in FIG. 13E, a deposition material having passed through the first opening 752a-1 may be arranged on a base substrate so as to form the 1-1 emission layer 222R-1 and the 1-2 emission layer 222R-2.

In this case, the third distance DL3 from the short side of the plan shape of the 1-2 emission area EA1-2 of the second distinguished organic light-emitting diode OLED1-2 to the plan shape of the third emission area EA3 of the third organic light-emitting diode OLED3 which faces the short side of the plan shape of the 1-2 emission area EA1-2 of the second distinguished organic light-emitting diode OLED1-2 may be decreased, compared to what is described with reference to FIGS. 11A and 11B. In this regard, the first distance DL1 from the long side of the plan shape of the 1-1 emission area EA1-1 of the first distinguished organic light-emitting diode OLED1-1 to the plan shape of the third emission area EA3 of the third organic light-emitting diode OLED3 which faces the long side of the plan shape of the 1-1 emission area EA1-1 of the first distinguished organic light-emitting diode OLED1-1, the second distance DL2 from the short side of the plan shape of the 1-1 emission area EA1-1 of the first distinguished organic light-emitting diode OLED1-1 to the plan shape of the second emission area EA2 of the second organic light-emitting diode OLED2 which faces the short side of the plan shape of the 1-1 emission area EA1-1 of the first distinguished organic light-emitting diode OLED1-1, and the fourth distance DL4 from a long side of the plan shape of the 1-2 emission area EA1-2 of the second distinguished organic light-emitting diode OLED1-2 to the plan shape of the second emission area EA2 of the second organic light-emitting diode OLED2 which faces the long side of the plan shape of the 1-2 emission area EA1-2 of the second distinguished organic light-emitting diode OLED1-2 may be all equal to what are described with reference to FIGS. 11A and 11B.

In the case above, the third distance DL3 may be smaller than each of the first distance DL1, the second distance DL2, and the fourth distance DL4, and when the 1-2 emission layer 222R-2 is arranged, a problem may occur because the 1-2 emission layer 222R-2 overlaps the third emission area EA3. In particular, in the case above, in order to sufficiently ensure the third distance DL3, a size of the first opening 752a-1 used to form the 1-2 emission layer 222R-2 has to be decreased or a pattern opening of a mask assembly used to form the third emission layer 222B has to be formed small. In this case, the 1-2 emission layer 222R-2 and the third emission layer 222B are mixed with each other in the third emission area EA3 or a size of the third emission layer 222B has to be decreased, so that an aperture ratio of the third organic light-emitting diode OLED3 may be decreased, compared to what is described with reference to FIGS. 11A and 11B. In particular, in this case, not only a resolution of the display panel may deteriorate but also an operation of the display panel may have a problem.

In one or more embodiments, the problem above may also occur in a case in which the first opening 752a-1 shown in one of FIG. 13C or 13E is arranged in one of the first pattern portion DDA1 or the second pattern portion DDA2 shown in FIG. 13B, and the first opening 752a-1 shown in the other one of FIG. 13C or 13E is arranged in the other one of the first pattern portion DDA1 or the second pattern portion DDA2 shown in FIG. 13B. Therefore, in the display apparatus and the electronic device according to one or more embodiments, when one display element is divided and arranged in one unit area, an entire aperture ratio of display elements implementing one color may be increased and respective aperture ratios of other display elements adjacent to the display elements may be ensured (e.g., maximally ensured). By doing so, a maximum aperture ratio with respect to all colors in a unit area PU may be ensured.

FIG. 14 is a plan view schematically illustrating a unit area of a display area of a display panel according to another embodiment.

Referring to FIG. 14, the display panel may include a substrate, a display layer, an encapsulation layer, a touch sensor layer, and an anti-reflection layer. In this regard, as the substrate, the display layer, the encapsulation layer, the touch sensor layer, and the anti-reflection layer are equal or similar to what are described with reference to FIGS. 10B and 10C, detailed descriptions thereof are omitted.

The display panel may include a display area and a peripheral area. The display area may include a unit area PU. The first distinguished organic light-emitting diode OLED1-1 and the second distinguished organic emitting diode OLED1-2 which are a first display element, the second organic light-emitting diode OLED2, and the third organic light-emitting diode OLED3 may be arranged in the unit area PU. Although not illustrated, a first sub-pixel circuit, a second sub-pixel circuit, and a third sub-pixel circuit may be arranged in the unit area PU, as described with reference to FIG. 11A. In this regard, the first sub-pixel circuit may be electrically connected to the first distinguished organic light-emitting diode OLED1-1 and the second distinguished organic emitting diode OLED1-2. The second sub-pixel circuit may be electrically connected to the second organic light-emitting diode OLED2, and the third sub-pixel circuit may be electrically connected to the third organic light-emitting diode OLED3.

Although not illustrated, the first distinguished organic light-emitting diode OLED1-1 and the second distinguished organic emitting diode OLED1-2 may be directly connected to the first sub-pixel circuit PC1 or may be connected to the first sub-pixel circuit PC1 via the sub-pixel connection electrode PCX. By doing so, the first distinguished organic light-emitting diode OLED1-1 and the second distinguished organic emitting diode OLED1-2 may simultaneously emit light of the same color or may not emit light of a color. A method of connecting the first distinguished organic light-emitting diode OLED1-1 and the second distinguished organic emitting diode OLED1-2 to the first sub-pixel circuit PC1 via the sub-pixel connection electrode PCX may be equal or similar to what is described with reference to FIG. 11A.

The plan shape of the 1-1 emission area EA1-1 of the first distinguished organic light-emitting diode OLED1-1, the plan shape of the 1-2 emission area EA1-2 of the second distinguished organic light-emitting diode OLED1-2, the plan shape of the second emission area EA2 of the second organic light-emitting diode OLED2, and the plan shape of the third emission area EA3 of the third organic light-emitting diode OLED3 may have an octagonal shape having a long side and a short side, which is equal or similar to what are described with reference to FIGS. 11A and 11B. Hereinafter, for convenience of descriptions, a case in which the plan shape of the 1-1 emission area EA1-1 of the first distinguished organic light-emitting diode OLED1-1, the plan shape of the 1-2 emission area EA1-2 of the second distinguished organic light-emitting diode OLED1-2, the plan shape of the second emission area EA2 of the second organic light-emitting diode OLED2, and the plan shape of the third emission area EA3 of the third organic light-emitting diode OLED3 are equal to what are shown in FIGS. 11A and 11B will be described in detail.

In the case above, a center of the plan shape of the 1-1 emission area EA1-1 of the first distinguished organic light-emitting diode OLED1-1, a center of the plan shape of the 1-2 emission area EA1-2 of the second distinguished organic light-emitting diode OLED1-2, a center of the plan shape of the second emission area EA2 of the second organic light-emitting diode OLED2, and a center of the plan shape of the third emission area EA3 of the third organic light-emitting diode OLED3 may each be arranged at a vertex of a quadrangle. In this regard, the quadrangle may have various shapes including a non-square rectangle, a rhombus, a parallelogram, a trapezoid, etc. Hereinafter, for convenience of descriptions, a case in which the center of the plan shape of the 1-1 emission area EA1-1 of the first distinguished organic light-emitting diode OLED1-1, the center of the plan shape of the 1-2 emission area EA1-2 of the second distinguished organic light-emitting diode OLED1-2, the center of the plan shape of the second emission area EA2 of the second organic light-emitting diode OLED2, and the center of the plan shape of the third emission area EA3 of the third organic light-emitting diode OLED3 are each arranged at a vertex of a non-square quadrangle will be described in detail.

In the case above, at least two of a first distance DL1, a second distance DL2, a third distance DL3, and a fourth distance DL4 may be different from each other.

Although not illustrated, the center of the plan shape of the 1-1 emission area EA1-1 of the first distinguished organic light-emitting diode OLED1-1, the center of the plan shape of the 1-2 emission area EA1-2 of the second distinguished organic light-emitting diode OLED1-2, the center of the plan shape of the second emission area EA2 of the second organic light-emitting diode OLED2, and the center of the plan shape of the third emission area EA3 of the third organic light-emitting diode OLED3 may be arranged on an arbitrary straight line parallel to a first direction (for example, one of x direction or y direction of FIG. 14) and/or a second direction (for example, the other one of x direction or y direction of FIG. 14).

Also, an arbitrary straight line extending from a long side of the plan shape of the 1-1 emission area EA1-1 of the first distinguished organic light-emitting diode OLED1-1 and an arbitrary straight line extending from a long side of the plan shape of the 1-2 emission area EA1-2 of the second distinguished organic light-emitting diode OLED1-2 may be perpendicular to each other.

One side of the plan shape of the 1-1 emission area EA1-1 of the first distinguished organic light-emitting diode OLED1-1 and/or one side of the plan shape of the 1-2 emission area EA1-2 of the second distinguished organic light-emitting diode OLED1-2 may be arranged within a distance between two parallel sides of the plan shape of the second emission area EA2 of the second organic light-emitting diode OLED2 and/or a distance between two parallel sides of the plan shape of the third emission area EA3 of the third organic light-emitting diode OLED3. That is, the plan shape of the 1-1 emission area EA1-1 of the first distinguished organic light-emitting diode OLED1-1 and/or the plan shape of the 1-2 emission area EA1-2 of the second distinguished organic light-emitting diode OLED1-2 may be arranged within an arbitrary area formed by an arbitrary straight line extending from the plan shape of the second emission area EA2 of the second organic light-emitting diode OLED2, the arbitrary straight line crossing an arbitrary straight line extending from the plan shape of the third emission area EA3 of the third organic light-emitting diode OLED3. For example, with respect to FIG. 14, the plan shape of the 1-1 emission area EA1-1 of the first distinguished organic light-emitting diode OLED1-1 may be arranged within a first area SA1 formed by an arbitrary straight line extending from a vertical line of the plan shape of the second emission area EA2 of the second organic light-emitting diode OLED2, the arbitrary straight line crossing an arbitrary straight line extending from a horizontal line of the plan shape of the third emission area EA3 of the third organic light-emitting diode OLED3. Also, with respect to FIG. 14, the plan shape of the 1-2 emission area EA1-2 of the second distinguished organic light-emitting diode OLED1-2 may be arranged within a second area SA2 formed by an arbitrary straight line extending from a horizontal line of the plan shape of the second emission area EA2 of the second organic light-emitting diode OLED2, the arbitrary straight line crossing an arbitrary straight line extending from a vertical line of the plan shape of the third emission area EA3 of the third organic light-emitting diode OLED3.

Although not illustrated, when a difference between an aperture ratio of the first organic light-emitting diode OLED1 and an aperture ratio of the second organic light-emitting diode OLED2 is equal to or less than 10 %, a third distinguished organic light-emitting diode and a fourth distinguished organic light-emitting diode may have structures similar to the first distinguished organic light-emitting diode OLED1-1 and the second distinguished organic light-emitting diode OLED1-2 which are described with reference to FIGS. 12A and 12B.

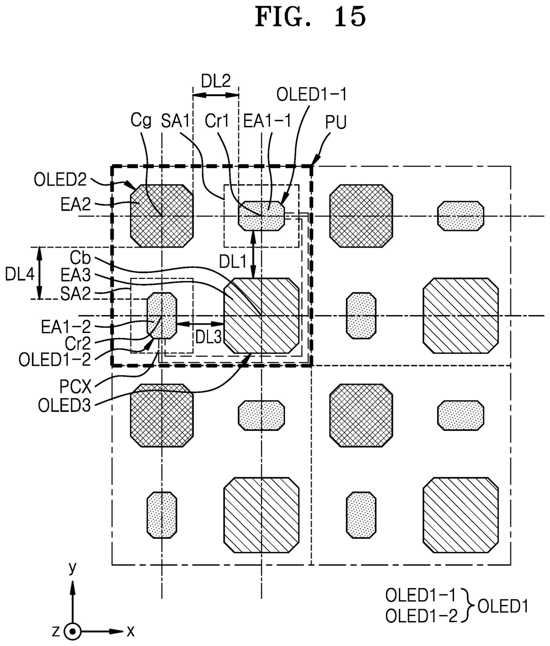

FIG. 15 is a plan view schematically illustrating a display area of a display panel according to another embodiment.

Referring to FIG. 15, the display panel may include a substrate, a display layer, an encapsulation layer, a touch sensor layer, and an anti-reflection layer. In this regard, as the substrate, the display layer, the encapsulation layer, the touch sensor layer, and the anti-reflection layer are equal or similar to what are described with reference to FIGS. 10B and 10C, detailed descriptions thereof are omitted.

The display panel may include a display area and a peripheral area. The display area may include a unit area PU. A first distinguished organic light-emitting diode OLED1-1 and a second distinguished organic light-emitting diode OLED1-2 which are a first display element, a second organic light-emitting diode OLED2, and a third organic light-emitting diode OLED3 may be arranged in the unit area PU. Although not illustrated, a first sub-pixel circuit, a second sub-pixel circuit, and a third sub-pixel circuit may be arranged in the unit area PU, as described with reference to FIG. 11A. In this regard, the first sub-pixel circuit may be electrically connected to the first distinguished organic light-emitting diode OLED1-1 and the second distinguished organic emitting diode OLED1-2. The second sub-pixel circuit may be electrically connected to the second organic light-emitting diode OLED2, and the third sub-pixel circuit may be electrically connected to the third organic light-emitting diode OLED3.

The first distinguished organic light-emitting diode OLED1-1 and the second distinguished organic emitting diode OLED1-2 may be directly connected to the first sub-pixel circuit or may be connected to the first sub-pixel circuit via the sub-pixel connection electrode PCX. By doing so, the first distinguished organic light-emitting diode OLED1-1 and the second distinguished organic emitting diode OLED1-2 may simultaneously emit light of the same color or may not emit color light. The sub-pixel connection electrode PCX may be arranged by bypassing the third organic light-emitting diode OLED3 along an edge of a plan shape of a unit area PU. In another embodiment, although not illustrated, the sub-pixel connection electrode PCX may be arranged by bypassing the second organic light-emitting diode OLED2. In another embodiment, the sub-pixel connection electrode PCX may be arranged as shown in FIG. 11A.

A plan shape of a 1-1 emission area EA1-1 of the first distinguished organic light-emitting diode OLED1-1 and a plan shape of a 1-2 emission area EA1-2 of the second distinguished organic light-emitting diode OLED1-2 may be a rectangle. In this regard, a corner of the plan shape of the 1-1 emission area EA1-1 of the first distinguished organic light-emitting diode OLED1-1 and a corner of the plan shape of the 1-2 emission area EA1-2 of the second distinguished organic light-emitting diode OLED1-2 may have a chamfered shape. The plan shape of the second emission area EA2 of the second organic light-emitting diode OLED2 and the plan shape of the third emission area EA3 of the third organic light-emitting diode OLED3 may be equal or similar to what are described with reference to FIGS. 11A and 11B.

One side of the plan shape of the 1-1 emission area EA1-1 of the first distinguished organic light-emitting diode OLED1-1 and/or one side of the plan shape of the 1-2 emission area EA1-2 of the second distinguished organic light-emitting diode OLED1-2 may be arranged within a distance between two parallel sides of the plan shape of the second emission area EA2 of the second organic light-emitting diode OLED2 and/or a distance between two parallel sides of the plan shape of the third emission area EA3 of the third organic light-emitting diode OLED3. That is, the plan shape of the 1-1 emission area EA1-1 of the first distinguished organic light-emitting diode OLED1-1 and/or the plan shape of the 1-2 emission area EA1-2 of the second distinguished organic light-emitting diode OLED1-2 may be arranged within an arbitrary area formed by an arbitrary straight line extending from the plan shape of the second emission area EA2 of the second organic light-emitting diode OLED2, the arbitrary straight line crossing an arbitrary straight line extending from the plan shape of the third emission area EA3 of the third organic light-emitting diode OLED3. For example, with respect to FIG. 15, the plan shape of the 1-1 emission area EA1-1 of the first distinguished organic light-emitting diode OLED1-1 may be arranged within a first area SA1 formed by an arbitrary straight line extending from a horizontal line of the plan shape of the second emission area EA2 of the second organic light-emitting diode OLED2 and an arbitrary straight line extending from a vertical line of the plan shape of the third emission area EA3 of the third organic light-emitting diode OLED3. Also, with respect to FIG. 15, the plan shape of the 1-2 emission area EA1-2 of the second distinguished organic light-emitting diode OLED1-2 may be arranged within a second area SA2 formed by an arbitrary straight line extending from a vertical line of the plan shape of the second emission area EA2 of the second organic light-emitting diode OLED2 and an arbitrary straight line extending from a horizotal line of the plan shape of the third emission area EA3 of the third organic light-emitting diode OLED3.

A first center Cr1, a second center Cr2, a third center Cg, and a fourth center Cb may each be arranged at a vertex of a virtual square. In this regard, the first center Cr1 and the second center Cr2 may be arranged in a diagonal direction with respect to a center of a unit area PU. Also, each pair of the first center Cr1 and the third center Cg, the first center Cr1 and the fourth center Cb, the second center Cr2 and the third center Cg, and the second center Cr2 and the fourth center Cb may be arranged on a straight line. A straight line passing through the first center Cr1 and the third center Cg and a straight line passing through the second center Cr2 and the fourth center Cb may trisect one side of the unit area PU. Also, a straight line passing through the second center Cr2 and the third center Cg and a straight line passing through the first center Cr1 and the fourth center Cb may trisect another side of the unit area PU.

A first distance DL1 from a long side of the plan shape of the 1-1 emission area EA1-1 of the first distinguished organic light-emitting diode OLED1-1 to the plan shape of the third emission area EA3 of the third organic light-emitting diode OLED3 which faces the long side of the plan shape of the 1-1 emission area EA1-1 of the first distinguished organic light-emitting diode OLED1-1, a second distance DL2 from a short side of the plan shape of the 1-1 emission area EA1-1 of the first distinguished organic light-emitting diode OLED1-1 to the plan shape of the second emission area EA2 of the second organic light-emitting diode OLED2 which faces the short side of the plan shape of the 1-1 emission area EA1-1 of the first distinguished organic light-emitting diode OLED1-1, a third distance DL3 from a long side of the plan shape of the 1-2 emission area EA1-2 of the second distinguished organic light-emitting diode OLED1-2 to the plan shape of the third emission area EA3 of the third organic light-emitting diode OLED3 which faces the long side of the plan shape of the 1-2 emission area EA1-2 of the second distinguished organic light-emitting diode OLED1-2, and a fourth distance DL4 from a short side of the plan shape of the 1-2 emission area EA1-2 of the second distinguished organic light-emitting diode OLED1-2 to the plan shape of the second emission area EA2 of the second organic light-emitting diode OLED2 which faces the short side of the plan shape of the 1-2 emission area EA1-2 of the second distinguished organic light-emitting diode OLED1-2 may be all equal.

Although not illustrated, when a difference between an aperture ratio of the first organic light-emitting diode OLED1 and an aperture ratio of the second organic light-emitting diode OLED2 is equal to or less than 10 %, only one first organic light-emitting diode OLED1 may be arranged in the unit area PU, and the second organic light-emitting diode OLED2 may include a third distinguished organic light-emitting diode that is a first distinguished display element and a fourth distinguished organic light-emitting diode that is a second distinguished display element. Here, a relation between the first organic light-emitting diode OLED1, the third distinguished organic light-emitting diode, the fourth distinguished organic light-emitting diode, and the third organic light-emitting diode OLED3 may be equal or similar to an aforementioned relation between the second organic light-emitting diode OLED2, the first distinguished organic light-emitting diode OLED1-1, the second distinguished organic light-emitting diode OLED1-2, and the third organic light-emitting diode OLED3.

In addition, although not illustrated, when a difference between an aperture ratio of the first organic light-emitting diode OLED1 and an aperture ratio of the second organic light-emitting diode OLED2 is equal to or less than 10 %, a third distinguished organic light-emitting diode and a fourth distinguished organic light-emitting diode may have structures similar to the first distinguished organic light-emitting diode OLED1-1 and the second distinguished organic light-emitting diode OLED1-2 which are described with reference to FIGS. 12A and 12B.

Although not illustrated, the first center Cr1, the second center Cr2, the third center Cg, and the fourth center Cb may each be arranged at a vertex of a non-square quadrangle, in a similar manner to what are described with reference to FIG. 14. Here, the plan shape of the 1-1 emission area EA1-1 of the first distinguished organic light-emitting diode OLED1-1 and the plan shape of the 1-2 emission area EA1-2 of the second distinguished organic light-emitting diode OLED1-2 may be respectively arranged within the first area SA1 and the second area SA2 described above.

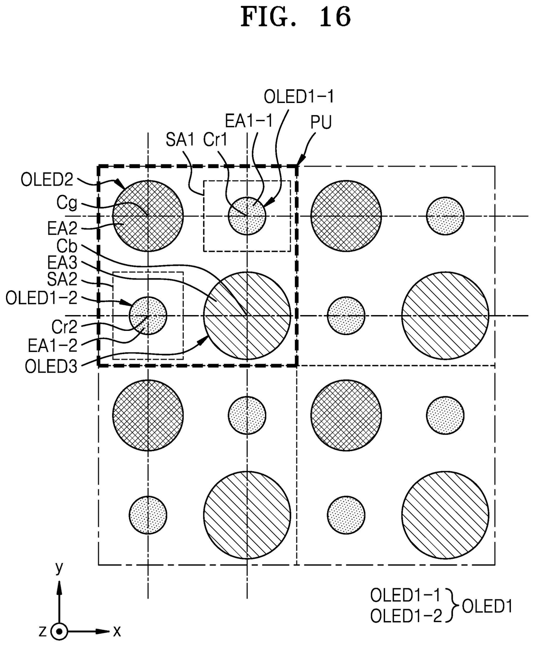

FIG. 16 is a plan view schematically illustrating a display area of a display panel according to another embodiment.

Referring to FIG. 16, the display panel may include a substrate, a display layer, an encapsulation layer, a touch sensor layer, and an anti-reflection layer. In this regard, as the substrate, the display layer, the encapsulation layer, the touch sensor layer, and the anti-reflection layer are equal or similar to what are described with reference to FIGS. 10B and 10C, detailed descriptions thereof are omitted.

The display panel may include a display area and a peripheral area. The display area may include a unit area PU. A first distinguished organic light-emitting diode OLED1-1 and a second distinguished organic light-emitting diode OLED1-2 which are a first display element, a second organic light-emitting diode OLED2, and a third organic light-emitting diode OLED3 may be arranged in the unit area PU. Although not illustrated, a first sub-pixel circuit, a second sub-pixel circuit, and a third sub-pixel circuit may be arranged in the unit area PU, as described with reference to FIG. 11A. In this regard, the first sub-pixel circuit may be electrically connected to the first distinguished organic light-emitting diode OLED1-1 and the second distinguished organic emitting diode OLED1-2. The second sub-pixel circuit may be electrically connected to the second organic light-emitting diode OLED2, and the third sub-pixel circuit may be electrically connected to the third organic light-emitting diode OLED3.

Although not illustrated, the first distinguished organic light-emitting diode OLED1-1 and the second distinguished organic emitting diode OLED1-2 may be directly connected to the first sub-pixel circuit or may be connected to the first sub-pixel circuit via a sub-pixel connection electrode. By doing so, the first distinguished organic light-emitting diode OLED1-1 and the second distinguished organic emitting diode OLED1-2 may simultaneously emit light of the same color or may not emit color light. A method of connecting the first distinguished organic light-emitting diode OLED1-1 and the second distinguished organic emitting diode OLED1-2 to the first sub-pixel circuit via the sub-pixel connection electrode may be equal or similar to what is described with reference to FIG. 11A or 15.

A plan shape of a 1-1 emission area EA1-1 of the first distinguished organic light-emitting diode OLED1-1 and a plan shape of a 1-2 emission area EA1-2 of the second distinguished organic light-emitting diode OLED1-2 may be a circle. Also, a plan shape of a second emission area EA2 of the second organic light-emitting diode OLED2 and a plan shape of a third emission area EA3 of the third organic light-emitting diode OLED3 may be a circle. By doing so, visibility of light emitting at one display element may be improved at various angles.

In this regard, the plan shape of the 1-1 emission area EA1-1 of the first distinguished organic light-emitting diode OLED1-1 and the plan shape of the 1-2 emission area EA1-2 of the second distinguished organic light-emitting diode OLED1-2 may be respectively arranged within a first area SA1 and a second area SA2 which are formed by an arbitrary tangent line contacting the plan shape of the second emission area EA2 of the second organic light-emitting diode OLED2 and being parallel in each of a first direction(for example, one of x-axis direction and y-axis direction of FIG. 16) and a second direction and an arbitrary tangent line contacting the plan shape of the third emission area EA3 of the third organic light-emitting diode OLED3 and being parallel in each of the first direction and the second direction(for example, the other one of x-axis direction and y-axis direction of FIG. 16).

A first center Cr1, a second center Cr2, a third center Cg, and a fourth center Cb may each be arranged at a vertex of a virtual square. In this regard, the first center Cr1 and the second center Cr2 may be arranged in a diagonal direction with respect to a center of a unit area PU. Also, each pair of the first center Cr1 and the third center Cg, the first center Cr1 and the fourth center Cb, the second center Cr2 and the third center Cg, and the second center Cr2 and the fourth center Cb may be arranged on a straight line. A straight line passing through the first center Cr1 and the third center Cg and a straight line passing through the second center Cr2 and the fourth center Cb may trisect one side of the unit area PU. Also, a straight line passing through the second center Cr2 and the third center Cg and a straight line passing through the first center Cr1 and the fourth center Cb may trisect another side of the unit area PU.

Although not illustrated, when a difference between an aperture ratio of the first organic light-emitting diode OLED1 and an aperture ratio of the second organic light-emitting diode OLED2 is equal to or less than 10 %, only one first organic light-emitting diode OLED1 may be arranged in the unit area PU, and the second organic light-emitting diode OLED2 may include a third distinguished organic light-emitting diode that is a first distinguished display element and a fourth distinguished organic light-emitting diode that is a second distinguished display element. Here, a relation between the first organic light-emitting diode OLED1, the third distinguished organic light-emitting diode, the fourth distinguished organic light-emitting diode, and the third organic light-emitting diode OLED3 may be equal or similar to an aforementioned relation between the second organic light-emitting diode OLED2, the first distinguished organic light-emitting diode OLED1-1, the second distinguished organic light-emitting diode OLED1-2, and the third organic light-emitting diode OLED3.

In addition, although not illustrated, when a difference between an aperture ratio of the first organic light-emitting diode OLED1 and an aperture ratio of the second organic light-emitting diode OLED2 is equal to or less than 10 %, a third distinguished organic light-emitting diode and a fourth distinguished organic light-emitting diode may have structures similar to the first distinguished organic light-emitting diode OLED1-1 and the second distinguished organic light-emitting diode OLED1-2 which are described with reference to FIGS. 12A and 12B.

Although not illustrated, the first center Cr1, the second center Cr2, the third center Cg, and the fourth center Cb may each be arranged at a vertex of a non-square quadrangle, in a similar manner to what are described with reference to FIG. 14. Here, the plan shape of the 1-1 emission area EA1-1 of the first distinguished organic light-emitting diode OLED1-1 and the plan shape of the 1-2 emission area EA1-2 of the second distinguished organic light-emitting diode OLED1-2 may be respectively arranged within the first area SA1 and the second area SA2 described above.

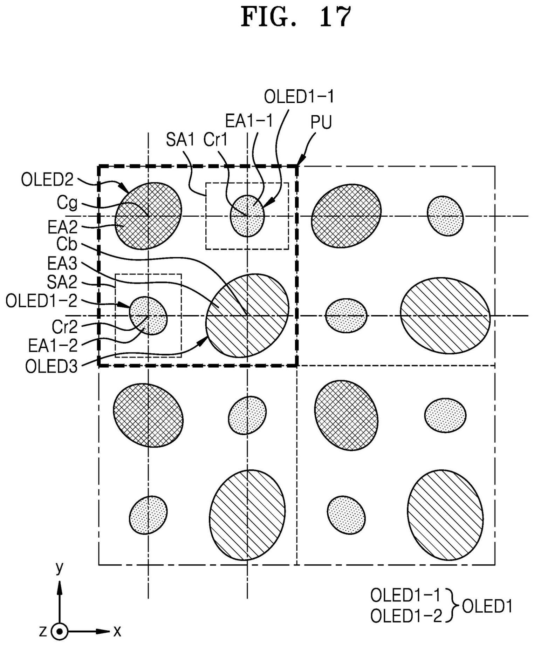

FIG. 17 is a plan view schematically illustrating a display area of a display panel according to another embodiment.

Referring to FIG. 17, the display panel may include a substrate, a display layer, an encapsulation layer, a touch sensor layer, and an anti-reflection layer. In this regard, as the substrate, the display layer, the encapsulation layer, the touch sensor layer, and the anti-reflection layer are equal or similar to what are described with reference to FIGS. 10B and 10C, detailed descriptions thereof are omitted.

The display panel may include a display area and a peripheral area. The display area may include a unit area PU. A first distinguished organic light-emitting diode OLED1-1 and a second distinguished organic light-emitting diode OLED1-2 which are a first display element, a second organic light-emitting diode OLED2, and a third organic light-emitting diode OLED3 may be arranged in the unit area PU. Although not illustrated, a first sub-pixel circuit, a second sub-pixel circuit, and a third sub-pixel circuit may be arranged in the unit area PU, as described with reference to FIG. 11A. In this regard, the first sub-pixel circuit may be electrically connected to the first distinguished organic light-emitting diode OLED1-1 and the second distinguished organic emitting diode OLED1-2. The second sub-pixel circuit may be electrically connected to the second organic light-emitting diode OLED2, and the third sub-pixel circuit may be electrically connected to the third organic light-emitting diode OLED3.

The first distinguished organic light-emitting diode OLED1-1 and the second distinguished organic emitting diode OLED1-2 may be directly connected to the first sub-pixel circuit or may be connected to the first sub-pixel circuit via the sub-pixel connection electrode PCX. By doing so, the first distinguished organic light-emitting diode OLED1-1 and the second distinguished organic emitting diode OLED1-2 may simultaneously emit light of the same color or may not emit color light. A method of connecting the first distinguished organic light-emitting diode OLED1-1 and the second distinguished organic emitting diode OLED1-2 to the first sub-pixel circuit via the sub-pixel connection electrode may be equal or similar to what is described with reference to FIG. 11A or 15.

A plan shape of a 1-1 emission area EA1-1 of the first distinguished organic light-emitting diode OLED1-1, a plan shape of a 1-2 emission area EA1-2 of the second distinguished organic light-emitting diode OLED1-2, a plan shape of a second emission area EA2 of the second organic light-emitting diode OLED2, and a plan shape of a third emission area EA3 of the third organic light-emitting diode OLED3 may be an oval. In this case, the plan shape of the 1-1 emission area EA1-1 of the first distinguished organic light-emitting diode OLED1-1 arranged in different unit areas PU may be arrayed in different directions. For example, the plan shape of the 1-1 emission area EA1-1 of the first distinguished organic light-emitting diode OLED1-1 arranged in a unit area PU may have a long axis and a short axis. A long axis of the plan shape of the 1-1 emission area EA1-1 of the first distinguished organic light-emitting diode OLED1-1 arranged in each unit area PU may have a different angle with respect to an arbitrary straight line. In the relation described above, an angle that is formed with respect to the arbitrary straight line by a long axis of the plan shape of the 1-1 emission area EA1-1 of the first distinguished organic light-emitting diode OLED1-1 may vary in all first distinguished organic light-emitting diodes OLED1-1 arranged in an entire display area. In another embodiment, an angle that is formed with respect to an arbitrary straight line (for example, x-axis or y-axis of FIG. 16) by a long axis of the plan shape of the 1-1 emission area EA1-1 of the first distinguished organic light-emitting diode OLED1-1 included in each of a plurality of unit areas PU in a portion of a display area may vary in all first distinguished organic light-emitting diodes OLED1-1 included in the plurality of unit areas PU in the portion of the display area. In this case, the plurality of unit areas PU arranged in the portion of the display area may be grouped, and the group may be uniformly arranged in the display area so as to form the display area. For example, in FIG. 16, four unit areas PU may be arranged to be adjacent to each other in a display area so as to form the display area.

The relation described above may be applied to a second organic light-emitting diode OLED2 and a third organic light-emitting diode OLED3 which are arranged in each four unit area PU.

Respective long axes of a first distinguished organic light-emitting diode OLED1-1, a second distinguished organic light-emitting diode OLED1-2, a second organic light-emitting diode OLED2, and a third organic light-emitting diode OLED3 which are arranged in one unit area PU may have different angles with respect to an arbitrary straight line.

In this regard, the plan shape of the 1-1 emission area EA1-1 of the first distinguished organic light-emitting diode OLED1-1 and the plan shape of the 1-2 emission area EA1-2 of the second distinguished organic light-emitting diode OLED1-2 may be respectively arranged within a first area SA1 and a second area SA2 which are formed by an arbitrary tangent line extending in a direction parallel to a first direction (for example, one of x-axis or y-axis of FIG. 17) and a second direction (for example, the other one of x-axis or y-axis of FIG. 17) and contacting the plan shape of the second emission area EA2 of the second organic light-emitting diode OLED2, the arbitrary tangent line crossing an arbitrary tangent line extending in a direction parallel to the first direction and the second direction and contacting the plan shape of the third emission area EA3 of the third organic light-emitting diode OLED3.

A first center Cr1, a second center Cr2, a third center Cg, and a fourth center Cb may each be arranged at a vertex of a virtual square. In this regard, the first center Cr1 and the second center Cr2 may be arranged in a diagonal direction with respect to a center of a unit area PU. Also, each pair of the first center Cr1 and the third center Cg, the first center Cr1 and the fourth center Cb, the second center Cr2 and the third center Cg, and the second center Cr2 and the fourth center Cb may be arranged on a straight line. A straight line passing through the first center Cr1 and the third center Cg and a straight line passing through the second center Cr2 and the fourth center Cb may trisect one side of the unit area PU. Also, a straight line passing through the second center Cr2 and the third center Cg and a straight line passing through the first center Cr1 and the fourth center Cb may trisect another side of the unit area PU.

Although not illustrated, when a difference between an aperture ratio of the first organic light-emitting diode OLED1 and an aperture ratio of the second organic light-emitting diode OLED2 is equal to or less than 10 %, only one first organic light-emitting diode OLED1 may be arranged in the unit area PU, and the second organic light-emitting diode OLED2 may include a third distinguished organic light-emitting diode that is a first distinguished display element and a fourth distinguished organic light-emitting diode that is a second distinguished display element. Here, a relation between the first organic light-emitting diode OLED1, the third distinguished organic light-emitting diode, the fourth distinguished organic light-emitting diode, and the third organic light-emitting diode OLED3 may be equal or similar to an aforementioned relation between the second organic light-emitting diode OLED2, the first distinguished organic light-emitting diode OLED1-1, the second distinguished organic light-emitting diode OLED1-2, and the third organic light-emitting diode OLED3.

In addition, although not illustrated, when a difference between an aperture ratio of the first organic light-emitting diode OLED1 and an aperture ratio of the second organic light-emitting diode OLED2 is equal to or less than 10 %, a third distinguished organic light-emitting diode and a fourth distinguished organic light-emitting diode may have structures similar to the first distinguished organic light-emitting diode OLED1-1 and the second distinguished organic light-emitting diode OLED1-2 which are described with reference to FIGS. 12A and 12B.

Although not illustrated, the first center Cr1, the second center Cr2, the third center Cg, and the fourth center Cb may each be arranged at a vertex of a non-square quadrangle, in a similar manner to what are described with reference to FIG. 14. Here, the plan shape of the 1-1 emission area EA1-1 of the first distinguished organic light-emitting diode OLED1-1 and the plan shape of the 1-2 emission area EA1-2 of the second distinguished organic light-emitting diode OLED1-2 may be respectively arranged within the first area SA1 and the second area SA2 described above.

In a display panel and an electronic device according to embodiments, an emission area of one sub-pixel arranged in one unit area may be increased.

The display panel and the electronic device according to embodiments may provide a sharp image.

In the display panel and the electronic device according to embodiments, an emission area of all sub-pixels arranged in one unit area may be maximally ensured.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display panel (10) comprising:
a substrate (100) including a display area (DA); and
a plurality of unit areas (PU) arranged on the substrate (100), the plurality of unit areas (PU) being adjacent to each other in the display area (DA),
wherein each of the plurality of unit areas (PU) comprises a first display element (OLED1), a second display element (OLED2), and a third display element (OLED3) configured to emit light of different colors,
wherein the first display element (OLED1), the second display element (OLED2), and the third display element (OLED3) are arranged in each of the plurality of unit areas (PU),
wherein the first display element (OLED1) comprises:
a first distinguished display element (OLED1-1) in which a plan shape of an emission area (EA1-1) is a polygon having a long side and a short side; and
a second distinguished display element (OLED1-2) that is spaced from the first distinguished display element (OLED1-1) and in which a plan shape of an emission area (EA1-2) is a polygon having a long side and a short side, and
wherein the long side of the polygon of the emission area (EA1-1) of the first distinguished display element (OLED1-1) is perpendicular to the long side of the polygon of the emission area (EA1-2) of the second distinguished display element (OLED1-2).

2. The display panel (10) of claim 1, wherein a distance (DL2) from an edge of a plan shape of an emission area (EA2, EA3) of one of the second display element (OLED2) or the third display element (OLED3), the one being adjacent to the long side of the polygon of the emission area (EA1-1) of the first distinguished display element (OLED1-1), to the long side of the polygon of the emission area (EA1-1) of the first distinguished display element (OLED1-1) is equal to a distance (DL1) from an edge of a plan shape of an emission area (EA2, EA3) of the other one of the second display element (OLED2) and the third display element (OLED3), the other one being adjacent to the short side of the polygon of the emission area (EA1-1) of the first distinguished display element (OLED1-1), to the short side of the polygon of the emission area (EA1-1) of the first distinguished display element (OLED1-1).

3. The display panel (10) of claim 1 or 2, wherein the plan shape of the emission area (EA1-1) of the first distinguished display element (OLED1-1) and the plan shape of the emission area (EA1-2) of the second distinguished display element (OLED1-2) are a rectangular shape or an octagonal shape.

4. A display panel (10) comprising:
a substrate (100) comprising a display area (DA); and
a plurality of unit areas (PU) arranged on the substrate (100), and arranged to be adjacent to each other in the display area (DA),
wherein each unit area (PU) comprises a first display element (OLED1), a second display element (OLED2), and a third display element (OLED3) which emit light of different colors,
the first display element (OLED1), the second display element (OLED2), and the third display element (OLED3) are arranged in each unit area (PU),
the first display element (OLED1) comprises:
a first distinguished display element (OLED1-1) in which a plan shape of an emission area (EA1-1) is a circle or an oval; and
a second distinguished display element (OLED1-2) that is arranged apart from the first distinguished display element (OLED1-1) and in which a plan shape of an emission area (EA1-1) is a circle or an oval.

5. The display panel (10) of at least one of claims 1 to 4, further comprising a plurality of sub-pixel circuits (PC) arranged in each of the plurality of unit areas (PU), and connected to each of the first display element (OLED1), the second display element (OLED2), and the third display element (OLED3),
wherein one of the plurality of sub-pixel circuits (PC) is concurrently connected to the first distinguished display element (OLED1-1) and the second distinguished display element (OLED1-2).

6. The display panel (10) of at least one of claims 1 to 5, wherein the first distinguished display element (OLED1-1) and the second distinguished display element (OLED1-2) are configured to emit red light or green light.

7. The display panel (10) of at least one of claims 1 to 6, wherein, when the first distinguished display element (OLED1-1) emits light, the first distinguished display element (OLED1-1) and the second distinguished display element (OLED1-2) concurrently emit light of a same color.

8. The display panel (10) of at least one of claims 1 to 7, wherein each of a center (Cr1) of the plan shape of the emission area (EA1-1) of the first distinguished display element (OLED1-1), a center (Cr2) of the plan shape of the emission area (EA1-2) of the second distinguished display element (OLED1-2), a center (Cg) of a plan shape of an emission area (EA2) of the second display element (OLED2), and a center (Cb) of a plan shape of an emission area (EA3) of the third display element (OLED3) is arranged at a vertex of a square.

9. The display panel (10) of at least one of claims 1 to 8, wherein one of a center (Cr1) of the plan shape of the emission area (EA1-1) of the first distinguished display element (OLED1-1) or a center (Cr2) of the plan shape of the emission area (EA1-2) of the second distinguished display element (OLED1-2) and a center (Cg) of a plan shape of an emission area (EA2) of the second display element (OLED2), which are arranged in each of the plurality of unit areas (PU), are arranged on a straight line, and/or wherein one of a center (Cr1) of the plan shape of the emission area (EA1-1) of the first distinguished display element (OLED1-1) or a center (Cr2) of the plan shape of the emission area (EA1-2) of the second distinguished display element (OLED1-2) and a center (Cb) of a plan shape of an emission area (EA3) of the third display element (OLED3), which are arranged in each of the plurality of unit areas (PU), are arranged on a straight line.

10. The display panel (10) of at least one of claims 1 to 9, wherein a center (Cr1) of the plan shape of the emission area (EA1-1) of the first distinguished display element (OLED1-1) and a center (Cr2) of the plan shape of the emission area (EA1-2) of the second distinguished display element (OLED1-2) are arranged in a diagonal direction in each of the plurality of unit areas (PU).

11. The display panel (10) of at least one of claims 1 to 10, wherein a center (Cr1) of the plan shape of the emission area (EA1-1) of the first distinguished display element (OLED1-1) and a center (Cr2) of the plan shape of the emission area (EA1-2) of the second distinguished display element (OLED1-2) which are arranged in the display area (DA) are arrayed in a serpentine shape.

12. The display panel (10) of at least one of claims 1 to 11, further comprising an anti-reflection layer (600) on the first display element (OLED1), the second display element (OLED2), and the third display element (OLED3), the anti-reflection layer (600) comprising a color filter (620R, 620G, 620B).

13. The display panel (10) of at least one of claims 1 to 12, wherein, when each of the first display element (OLED1), the second display element (OLED2), and the third display element (OLED3) having different aperture ratios is arranged in each of the plurality of unit areas (PU), the first display element (OLED1) has a smallest aperture ratio from among the first display element (OLED1), the second display element (OLED2), and the third display element (OLED3) arranged in each of the plurality of unit areas (PU), and/or a difference between an aperture ratio of the first display element (OLED1) and an aperture ratio of one of the second display element (OLED2) or the third display element (OLED3), the one having a smallest aperture ratio, is equal to or less than 10 %.

14. The display panel (10) of at least one of claims 1 to 13, wherein one side of the plan shape of the emission area (EA1-1) of the first distinguished display element (OLED1-1) and/or one side of the plan shape of the emission area (EA1-2) of the second distinguished display element (OLED1-2) are arranged within a distance between two parallel sides of the plan shape of the emission area (EA2) of the second display element (OLED2) and/or arranged within a distance between two parallel sides of the plan shape of the emission area (EA3) of the third display element (OLED3).

15. An electronic device (1) comprising the display panel (10) according to at least one of claims 1 to 14.
